(19) Europäisches Patentamt / European Patent Office / Office européen des brevets

(11) **EP 2 325 669 B1**

(12) **EUROPÄISCHE PATENTSCHRIFT**

(45) Veröffentlichungstag und Bekanntmachung des Hinweises auf die Patenterteilung:
**17.08.2016   Patentblatt 2016/33**

(51) Int Cl.:
*G01R 33/54* (2006.01)          *G01R 33/483* (2006.01)
*G01R 33/561* (2006.01)        *G01R 33/385* (2006.01)
*G01R 33/3415* (2006.01)

(21) Anmeldenummer: **10186692.9**

(22) Anmeldetag: **06.10.2010**

(54) **Verfahren zur ortsabhängigen Änderung der Magnetisierung in einem Objekt im Rahmen eines Experimentes der magnetischen Resonanz**

Method for location-dependent alteration of the magnetisation in an object as part of a magnetic resonance experiment

Procédé de modification en fonction de la position de la magnétisation dans un objet dans le cadre d'une expérience de résonance magnétique

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.10.2009   DE 102009045464**

(43) Veröffentlichungstag der Anmeldung:
**25.05.2011   Patentblatt 2011/21**

(73) Patentinhaber:
• **Bruker BioSpin MRI GmbH**
  **76275 Ettlingen (DE)**
• **Universitätsklinikum Freiburg**
  **78106 Freiburg (DE)**

(72) Erfinder:
• **Haas, Martin**
  **79104 Freiburg (DE)**
• **Ullmann, Peter**
  **76137 Karlsruhe (DE)**
• **Ruhm, Wolfgang**
  **76275 Ettlingen (DE)**
• **Zaitsev, Maxim**
  **79117 Freiburg (DE)**
• **Hennig, Jürgen**
  **79100 Freiburg (DE)**

(74) Vertreter: **Kohler Schmid Möbus Patentanwälte Partnerschaftsgesellschaft mbB**
**Ruppmannstraße 27**
**70565 Stuttgart (DE)**

(56) Entgegenhaltungen:
**EP-A1- 2 237 060          DE-A1- 10 250 913**
**DE-A1- 19 616 388**

• **WELZ A.M. ET AL: "Initial realisation of a multichannel, non-linear PatLoc gradient coil" PROCEEDINGS OF THE INTERNATIONAL SOCIETY FOR MAGNETIC RESONANCE IN MEDICINE,16TH ANNUAL MEETING PROCEEDINGS, 3. Mai 2008 (2008-05-03), Seite 1163, XP002619844 Toronto, Canada**
• **XU, D.KING, K. F.ZHU, Y.MCKINNON, G. C.LIANG, Z. P.: "Designing Multichannel, Multidimensional, Arbitrary Flip Angle RF Pulses Using an Optimal Control Approach" MAGNETIC RESONANCE IN MEDICINE, Bd. 59, 2008, Seiten 547-560, XP007908761**
• **WU E X ET AL: "A new 3D localization technique using quadratic field gradients" MAGNETIC RESONANCE IN MEDICINE, Bd. 32, Nr. 2, August 1994 (1994-08), Seiten 242-245, XP002620096 USA ISSN: 0740-3194**
• **GRISSOM W ET AL: "Spatial domain method for the design of RF pulses in multicoil parallel excitation" MAGNETIC RESONANCE IN MEDICINE, Bd. 56, Nr. 3, 1. September 2006 (2006-09-01), Seiten 620-629, XP002475615 ACADEMIC PRESS, DULUTH, MN, US ISSN: 0740-3194 DOI: 10.1002/MRM.20978**

**Beschreibung**

Hintergrund der Erfindung

Die Erfindung betrifft ein Verfahren zur ortsabhängigen Änderung der Magnetisierung in einem Objekt, gemäß einer Vorgabe im Rahmen eines Experimentes der magnetischen Resonanz, wobei Hochfrequenzpulse in Kombination mit räumlich und zeitlich variierenden Zusatzmagnetfeldern, die dem längs einer z-Richtung ausgerichteten statischen und homogenen magnetischen Grundfeld einer Magnetresonanzmessapparatur überlagert werden, eingestrahlt werden.

Ein derartiges Verfahren ist beispielsweise bekannt aus Referenz [1].

Die bildgebende Magnetresonanz (MRI: Magnetic Resonance Imaging), auch als Magnetresonanztomographie (MRT) bezeichnet, ist eine weitverbreitete Technik zur nichtinvasiven Gewinnung von Bildern des Innern eines Untersuchungsobjektes und beruht auf der ortsaufgelösten Messung von Magnetresonanzsignalen aus dem Untersuchungsobjekt. Indem das Untersuchungsobjekt innerhalb des Untersuchungsvolumens einer Magnetresonanz-Messapparatur einem im Wesentlichen statischen und homogenen magnetischen Grundfeld, auch als Hauptmagnetfeld bezeichnet, ausgesetzt wird, werden in ihm enthaltene Kernspins bzgl. der Richtung des Grundfeldes, in der Regel als z-Richtung eines magnetgebundenen Koordinatensystems gewählt, orientiert. Die damit verbundene Ausrichtung der magnetischen Dipolmomente der Atomkerne führt zu einer Magnetisierung innerhalb des Objektes in Richtung des Hauptmagnetfeldes, die als Longitudinalmagnetisierung bezeichnet wird. Bei der MR-Untersuchung (MR: Magnetische Resonanz bzw. magnetic resonance) wird durch Einstrahlung von elektromagnetischen HF-Pulsen (HF: Hochfrequenz) mittels einer oder mehrerer HF-Sendeantennen diese Magnetisierung innerhalb des Untersuchungsobjekts zu einer Präzessionsbewegung angeregt, deren Frequenz proportional zu der lokalen magnetischen Feldstärke ist. Der Vektor der Magnetisierung wird dabei um einen Winkel, der im Folgenden als Auslenkungswinkel bezeichnet wird, aus der Gleichgewichtslage (z-Richtung) ausgelenkt.

Bei den heute allgemein verwendeten MRI-Verfahren wird den Präzessionsbewegungen der Kernspins durch zeitlich variierte Überlagerungen von zusätzlichen ortsabhängigen Magnetfeldern, im Folgenden als Zusatzmagnetfelder bezeichnet, für alle drei Raumrichtungen eine räumliche Kodierung, im Allgemeinen als Ortskodierung bezeichnet, aufgeprägt. Diese Zusatzmagnetfelder weisen üblicherweise innerhalb des Untersuchungsobjekts im wesentlichen konstante Gradienten der z-Komponente in den Raumrichtungen x, y und z auf und werden von einer als Gradientensystem bezeichneten Spulenanordnung, die für die Raumrichtungen jeweils von einem sog. Gradientenkanal angesteuert werden, erzeugt. Ist im Folgenden von linearen und nichtlinearen Magnetfeldern die Rede, ist dies, soweit nicht anders genannt, stets auf den räumlichen Verlauf der z-Komponente der Felder bezogen. Die Ortskodierung wird üblicherweise durch ein Schema in einem dem Ortsraum über eine Fouriertransformation konjugierten Raum, dem sog. k-Raum, beschrieben. In diesem k-Raum-Formalismus, der nur bei der Verwendung von Magnetfeldern mit im Raum konstantem Gradienten anwendbar ist, lässt sich das Schalten von Zusatzmagnetfeldpulsen als das Durchlaufen einer Trajektorie im k-Raum, der sog. k-Raum-Trajektorie, beschreiben.

Die Transversalkomponente der mit den Kernspins verbundenen präzedierenden Magnetisierung, im Folgenden auch Transversalmagnetisierung genannt, induziert in einer oder mehreren HF-Empfangsantennen, welche das Untersuchungsobjekt umgeben, Spannungssignale, die auch als Magnetresonanzsignale (MR-Signale) bezeichnet werden. Mittels Pulssequenzen, welche speziell gewählte Abfolgen von HF-Pulsen und Zusatzmagnetfeldpulsen (kurzzeitiges Anlegen von zeitlich konstanten oder veränderlichen Zusatzmagnetfeldern) enthalten, werden zeitlich veränderliche Magnetresonanzsignale derart erzeugt, dass sie in entsprechende räumliche Abbildungen umgesetzt werden können. Dies erfolgt nach einer von vielen wohlbekannten Rekonstruktionstechniken, nachdem die MR-Signale mittels eines elektronischen Empfangssystems aufgenommen, verstärkt und digitalisiert, sowie mittels eines elektronischen Rechnersystems verarbeitet und in ein- oder mehrdimensionale Datensätze abgespeichert worden sind. Typischerweise enthält die verwendete Pulssequenz eine Abfolge von Messabläufen, als Phasenkodierschritte bezeichnet, in denen die Gradientenpulse gemäß dem gewählten Ortskodierungsverfahren variiert werden.

Die ortsabhängige Änderung der Magnetisierung, im Folgenden kurz SDMM bezeichnet, (SDMM: Spatially Dependent Modification of Magnetization) ist eine in der Magnetresonanzbildgebung weit verbreitete Technik, welche dazu genutzt wird, eine zu einem Zeitpunkt vorhandene Magnetisierung in einem Untersuchungsobjekt ortsabhängig mittels Einstrahlung von HF-Pulsen in Kombination mit räumlich und zeitlich variierenden Zusatzmagnetfeldern in eine neue Magnetisierung überzuführen, d. h. für jeden Ort innerhalb des Untersuchungsobjektes wird die dort vorhandene Magnetisierung gezielt geändert oder in einen für diesen Ort spezifisch vorgegebenen Zustand gesetzt. Ein Beispiel hierfür ist die räumlich selektive Anregung, welche dazu dient, in einem Anregungsvolumen Transversalmagnetisierung räumlich eingeschränkt zu erzeugen und/oder deren Amplitude und Phase, vorgegebenen Verteilungen entsprechend, räumlich zu variieren.

Bei der Schichtselektion, dem häufigsten Fall der räumlich selektiven Anregung, wird das Anregungsvolumen auf eine vorgegebene Schicht reduziert. Die mehrdimensionale räumlich selektive Anregung, bei welcher das Anregungsvolumen in mehr als einer Richtung eingeschränkt und/oder die Anregung in mehr als einer Richtung moduliert wird, hat ebenfalls zahlreiche Anwendungen hervorgebracht. Zu nennen sind hier die Anregung eines kleinen dreidimensionalen Volumens innerhalb eines wesentlich größeren Untersuchungsobjektes für lokalisierte Spektroskopie, die Abbildung einer selektiv angeregten Region (ROI: Region of Interest) mit reduzierten Sichtfeld (FOV: Field of View) mit dem Ziel der Messzeitverkürzung oder Auflösungsverbesserung, die Anregung spezieller, an Strukturen des Untersuchungsobjekts angepasster Volumina oder auch die echo-planare Bildgebung mit reduzierten Echozuglängen.

Weiterhin kann die Amplituden- und Phasenmodulation der Transversalmagnetisierung bei der Anregung auch dazu genutzt werden, um nachteilige Effekte eines inhomogenen magnetischen Sendefeldes ($B_1$-Feld) der zum Anregen verwendeten HF-Sendeantennen zu kompensieren. Dies ist eine Anwendung, welche heutzutage aufgrund der starken Zunahme von Hochfeld-MRI-Systemen, an welchen derartige Inhomogenitäten besonders auftreten, immens an Bedeutung gewonnen hat. Neben ihrer Verwendung für die Anregung kann die SDMM aber auch zur räumlich selektiven Inversion oder Refokussierung der Magnetisierung genutzt werden.

Eine weitere interessante Anwendung von SDMM ist die gezielte Erzeugung einer Phasenverteilung der transversalen Magnetisierung während der Anregung. Bei dem in [15] beschriebenen Verfahren wird mittels dreidimensionaler selektiver Anregung bei der Anregung ein räumliches Phasenmuster der transversalen Magnetisierung der Kernspins erzeugt, wodurch suszeptibilitätsbedingte Dephasierungen des MR-Signals während eines Bildgebungsexperiments zumindest teilweise kompensiert und dadurch Signalverluste abgeschwächt werden. Dies wird dadurch erreicht, dass das zur Phasenkompensation verwendete Phasenmuster, d. h eine räumliche Phasenverteilung der Transversalmagnetisierung, vorab berechnet wird.

Bei dem in [16] offengelegten Verfahren, wird eine solche Erzeugung von Phasenmustern der transversalen Magnetisierung während der Anregung dazu verwendet, eine teilweise oder vollständige Ortskodierung der Magnetresonanzsignale während der Anregung zu erzielen. Durch wiederholte Anregung mit unterschiedlichen, gemäß einem Phasenkodierschema festgelegten Phasenmustern und jeweils nachfolgender Datenaufnahme wird in mehreren Phasenkodierschritten ein Gesamtdatensatz gewonnen, der dann dem Ortskodierschema entsprechend ortsaufgelöst rekonstruiert wird und z. B. zwei- oder dreidimensionale Bilder des Untersuchungsobjekts liefert. Dieses Verfahren zur Ortskodierung wird im Folgenden als Anregungskodierung bezeichnet.

Zunächst wurde die SDMM in der Vergangenheit mittels einer einzelnen HF-Sendeantenne mit einem im Wesentlichen homogenen Sendefeld ($B_1$-Feld) in Kombination mit dem Gradientensystem durchgeführt. Inspiriert durch den Erfolg der Parallelen Bildgebung, bei welcher die Signalaufnahme mit einer Anordnung von mehreren HF-Antennen, in der Fachliteratur auch als Antennenarray, bestehend aus mehreren Einzelantennen oder Elementen, bezeichnet, durchgeführt wird, ist man inzwischen dazu übergegangen, auch bei der SDMM solche aus mehreren Elementen bestehende Antennenarrays, betrieben an mehreren unabhängigen HF-Sendekanälen der MR-Messapparatur, zum Senden einzusetzen. Damit ist man in der Lage, die Ortskodierung, welche bei der SDMM in Analogie zur Datenaufnahme durch Variation von Zusatzmagnetfeldern realisiert wird, partiell durch sog. Sensitivitätskodierung zu ersetzen und damit die Länge der Anregungspulse zu reduzieren. Dies bedeutet, dass man die unterschiedlichen räumlichen Variationen der HF-Sendefelder der einzelnen Arrayelemente, im Folgenden auch als Sendeprofile bezeichnet, ausnutzt.

Da die Länge selektiver Anregungspulse im Einkanal-Sendefall meist eines der limitierenden Kriterien für die Anwendbarkeit dieser Technik war, ist die sog. Parallele Anregung (PEX: Parallel Excitation) oder mehrkanalige Anregung ein viel versprechender Ansatz, um räumlich selektive Anregung in noch breiterer Weise einzusetzen, als bisher geschehen. Die Ortskodierung während des Sendens von HF-Pulsen zum Zweck der selektiven Anregung, im Folgenden Sendeortskodierung genannt, ermöglicht, dass Amplitude und Phase der während des Sendevorgangs erzeugten transversalen Magnetisierung ortsabhängig eingestellt werden können. Diese Sendeortskodierung ist einerseits von der klassischen Ortskodierung im Akquisitionsfall zu unterschieden, welche im Rahmen der Datenaufnahme in einer der Anregung nachgelagerten Periode ohne HF-Einstrahlung, insbesondere auch während der Datenaufnahme, erfolgt, und andererseits von der bereits oben erwähnten Anregungskodierung, bei der bereits nach der Anregungsperiode eine ortskodierende Phasenverteilung der Transversalmagnetisierung der Kernspins vorliegt.

Eine der Grundaufgaben beim Einsatz der SDMM ist die Bestimmung der HF-Pulse, welche vom HF-Sendesystem der MR-Messapparatur abgespielt werden müssen, um in Kombination mit Zusatzmagnetfeldern die gewünschte ortsabhängige Änderung der Magnetisierung zu generieren. Im eingangs zitierten Artikel "Designing Multichannel, Multidimensional, Arbitrary Flip Angle RF Pulses Using an Optimal Control Approach" (Referenz [1]) beschreiben Xu et al. ein Verfahren für die mehrkanalige ortsabhängige Änderung der Magnetisierung, mit welchem die gesuchten HF-Pulsformen $B_{1,n}(t)$ für jeden der I=1..n Sendekanäle auf Basis der vorgegebenen durch lineare Gradienten zu erzeugenden k-Raum-Trajektorie berechnet werden kann.

Grundlage für die Berechnungsverfahren der zur SDMM verwendeten HF-Pulse sind im Allgemeinen die wohlbekannten Blochgleichungen zur Beschreibung der Entwicklung der Magnetisierung in einem Objekt während der Einwirkung äußerer Magnetfelder. In [1] wird das Pulsdesign-Problem auf Basis der Blochgleichungen als ein "Optimal Control"-Problem formuliert und durch dessen Lösung die gesuchten HF-Pulse ermittelt.

Wie zuvor beschrieben, werden in der Magnetresonanzbildgebung sowie in der ortsaufgelösten Magnetresonanzspektroskopie zur Ortskodierung sowohl bei der Bildakquisition als auch bei der SDMM üblicherweise Zusatzmagnetfelder verwendet, welche im gesamten Untersuchungsvolumen der MR-Mess-apparatur jeweils in einer Raumrichtung einen räumlich konstanten Gradienten aufweisen. Aufgrund dieser Eigenschaft, das gesamte Untersuchungsvolumen abzudecken, werden diese Zusatzmagnetfelder als globale Gradienten bezeichnet, die erzeugende Systemkomponente als globales Gradientensystem. Ferner wird im Folgenden zur Vereinfachung der Darstellung davon ausgegangen, dass das Grundfeld in z-Richtung eines magnetgebundenen Koordinatensystems orientiert ist und dass die Gradienten in drei Ausprägungen $G_x$, $G_y$ und $G_z$ geschaltet werden können, deren z-Komponenten in zueinander orthogonalen Richtungen im wesentlichen linear mit einstellbarer Stärke ansteigen (siehe Referenzen [2],[3]).

Dabei bietet die Anwendung möglichst starker Gradienten, d. h. die Ausbildung einer möglichst großen Magnetfelddifferenz zwischen den Rändern des Untersuchungsvolumens, wesentliche Vorteile, von denen die Realisierung einer sehr hohen Ortsauflösung genannt sei. Ebenso ist ein möglichst schnelles Schaltverhalten beim An- und Ausschalten dieser Gradienten sowie beim Einstellen der Gradientenstärke vorteilhaft, z. B. zur Verkürzung des gesamten Messvorgangs.

Nachteilig beim Einsatz von globalen Gradienten ist, dass die für typische Anwendungen erforderlichen Gradientenstärken erheblichen Magnetfeldunterschieden zwischen den Rändern des Abbildungsgebietes entsprechen. Einerseits stößt deren Realisierung an technische Limitierungen bei der Konstruktion von Gradientenspulen und bei der Auslegung der Gradientenverstärker bzgl. der Größe und des Schaltverhaltens der zu generierenden elektrischen Ströme durch die Gradientenspulen. Andererseits treten beim schnellen Schalten dieser Magnetfelder schnell veränderliche Lorentzkräfte in den Komponenten der MR-Messapparatur auf, die nachteilig zu sehr großen mechanischen Beanspruchungen der MR-Messapparatur und zu übermäßigen Lärmemissionen führen können. Eine weitere Limitierung stellen neuronale Stimulationen lebender Untersuchungsobjekte durch schnell veränderliche Magnetfeldstärken dar, so dass in vielen Fällen die prinzipiell technisch erreichbare Bildqualität durch physiologische Einschränkungen bzgl. akustischer Belastung und Nervenstimulation nicht realisiert werden kann.

Zur Vermeidung dieser Limitierungen globaler Gradienten wurden im Rahmen der Akquisition von Magnetresonanzsignalen sog. lokale Gradienten eingeführt (siehe Referenzen [4],[5]), die in der Regel mit einem zusätzlich zu dem globalen Gradientensystem in die Apparatur eingebrachten lokalen Gradientensystem erzeugt werden. Eine erste experimentelle Realisierung eines solchen lokalen Gradientensystems mit multipolarer, nichtlinearer Geometrie ist in Welz A.M. et al, "Initial realisation of a multichannel, non-linear PatLoc gradient coil", Proc. Intl. Soc. Mag. Reson. Med., 2008, Seite 1163 beschrieben. Mit einem solchen lokalen Gradientensystem werden ebenfalls der Ortskodierung dienende Zusatzmagnetfelder erzeugt. Im Gegensatz zu globalen Gradienten ist bei lokalen Gradienten jedoch die z-Komponente $B_z(x,y,z)$ jeder einzelnen Ausprägung des Zusatzmagnetfeldes nur innerhalb einer oder innerhalb mehrerer ausgedehnter und in sich zusammenhängender Teilregionen des Untersuchungsvolumens entlang der Gradientenrichtung der z-Komponente ($\partial B_z(x,y,z)/\partial x$, $\partial B_z(x,y,z)\partial y$, $\partial B_z(x,y,z)/\partial z$) jeweils entweder monoton steigend oder monoton fallend. Im gesamten Untersuchungsvolumen liegt jedoch kein durchgängiger monotoner Verlauf von $B_z$ entlang dieser Gradientenrichtung vor. Mit einer Ausprägung eines solchen lokalen Zusatzmagnetfeldes kann eine eindimensionale Ortsbestimmung entlang der genannten Gradientenrichtung vorgenommen werden und Komponenten der aufgenommenen Magnetresonanzsignale können einzelnen Isoflächen der z-Komponenten $B_z(x,y,z)$ der entsprechenden Ausprägung des Zusatzmagnetfeldes zugeordnet werden. Diese Isomagnetfeldflächen stehen lokal senkrecht auf den Gradientenrichtungen und müssen für die Ortsrekonstruktion aus den Magnetresonanzsignalen prinzipiell bekannt sein.

Soll die Ortsbestimmung der Magnetresonanzsignale in mehreren räumlichen Dimensionen erfolgen, sind entsprechend viele geeignete Ausprägungen des Zusatzmagnetfeldes, im folgenden mit $F_1$, $F_2$, ... bezeichnet, erforderlich, die je nach Kodierverfahren auch gleichzeitig wirksam sein können. Bei mehrdimensionaler Ortskodierung mittels des lokalen Gradientensystems allein kann eine eindeutige Ortskodierung nur in den Regionen erfolgen, in denen alle dafür verwendeten Ausprägungen des Zusatzmagnetfeldes einen monotonen Verlauf in dem oben beschriebenen Sinn besitzen. Diese Regionen, in denen eine eindeutige Ortskodierung für alle gewünschten Dimension vorgenommen werden kann, werden im Folgenden als MSEM-Regionen (MSEM = monotonic spatially encoding magnetic field = monotones räumlich kodierendes Magnetfeld) bezeichnet.

Der Vorteil, der mit Hilfe solcher lokaler Gradienten gewonnen werden kann, ist, dass innerhalb jeder dieser MSEM-Regionen ein ortskodierendes Magnetfeld mit einem sehr steilen Anstieg und einem schnellen Schaltverhalten erzeugt werden kann, was u. a. für eine Erhöhung der Ortsauflösung bei der Akquisition von Magnetresonanzsignalen und/oder eine Verkürzung des Messvorgangs genutzt werden kann. Da dabei die Magnetfelddifferenz zwischen den Rändern einer MSEM-Region und damit auch die Magnetfeldvariation innerhalb des gesamten Untersuchungsvolumens wesentlich kleiner als im Falle globaler Gradienten gehalten werden kann, können die oben erwähnten Nachteile großer, zeitlich veränderlicher Magnetfeldvariationen innerhalb der Kernresonanzapparatur wesentlich reduziert bzw. vermieden werden.

Werden Magnetresonanzsignale aus dem gesamten Untersuchungsvolumen mit Hilfe eines solchen lokalen Gradientensystems ortskodiert, kann - im Falle einer nicht-ortsselektiven Signalerzeugung oder -aufnahme - i. allg. keine global, d. h. für das gesamte Untersuchungsobjekt, eindeutige räumliche Zuordnung der MR-Signale auf der Basis dieser Ortskodierung getroffen werden. Im Falle einer einzigen MSEM-Region kann nicht festgestellt werden, welcher Signalanteil aus dieser Region und welcher von außerhalb stammt, im Falle mehrerer MSEM-Regionen kann darüber hinaus i. allg. nicht differenziert werden, welche Signalanteile aus welcher dieser MSEM-Regionen stammen. Im Falle einer einzigen MSEM-Region wird dieses Problem üblicherweise dadurch gelöst, dass Anregungs- und/oder Empfangsantennen mit eingeschränkter räumlicher Sensitivität, insbesondere sog. Oberflächenspulen, eingesetzt werden, sodass nur Magnetresonanzsignale innerhalb dieser MSEM-Region angeregt und/oder gemessen werden. Im Falle von lokalen Gradientensystemen, die mehrere MSEM-Regionen besitzen, erfolgt die eindeutige Zuordnung der Signale dadurch, dass durch Einsatz eines Antennenarrays mit mindestens ebenso vielen, geeignet angeordneten Empfangselementen unterschiedlicher Sensitivität eine eindeutige Zuordnung getroffen werden kann, wie in den Referenzen [6] bis [11] beschrieben. Unter Umständen ist dafür ein komplexes Rekonstruktionsverfahren, z. B. eine SENSE-ähnliche Rekonstruktion (siehe Referenz [12]), erforderlich (Referenzen [8] bis [11]).

Im Gegensatz zu den voranstehend beschriebenen Entwicklungen im Bereich der Akquisition von Magnetresonanzsignalen wird die ortsabhängige Änderung der Magnetisierung SDMM nach dem Stand der Technik nach wie vor mit auf linearen Zusatzmagnetfeldern basierenden Verfahren durchgeführt und ist daher in ihrer Leistungsfähigkeit ebenfalls durch technische und physiologische Randbedingungen beschränkt. Diese Randbedingungen begrenzen die räumliche Auflösung, mit der die Änderung der Magnetisierung durchgeführt werden kann, und/oder erfordern eine gewisse Mindesteinstrahldauer der Kombination aus HF-Pulsen und Zusatzmagnetfeldern, um die gewünschte Änderung der Magnetisierung zu erreichen. Die Beschränkung dieser räumlichen Auflösung und die durch die Mindesteinstrahldauer bedingte Verzögerung innerhalb der MR-Messsequenz führen in vielen Fällen zu ungünstigeren Messbedingungen.

Aufgabe der Erfindung

Demnach ist es Aufgabe der vorliegenden Erfindung, ein Verfahren zur ortsabhängigen Änderung der Magnetisierung in einem Objekt gemäß einer Vorgabe anzugeben, bei welchem diese Änderung der Magnetisierung mit einer zumindest lokal räumlich höheren Auflösung und/oder einer zeitlich kürzeren Einstrahlungsdauer der HF-Pulse und Zusatzmagnetfelder realisiert wird, als dies nach dem Stand der Technik mit linearen Zusatzmagnetfeldern machbar ist, welche durch herkömmliche Gradientensysteme erzeugt werden. Dies soll insbesondere unter denselben technischen und physiologischen Randbedingungen möglich sein, die derzeit bei Verwendung linearer Zusatzfelder die Leistungsfähigkeit der nach dem Stand der Technik bekannten Verfahren einschränken.

Kurze Beschreibung der Erfindung

Erfindungsgemäß wird diese Aufgabe auf überraschend einfache, aber wirkungsvolle Weise dadurch gelöst, dass nicht-lineare Zusatzmagnetfelder angewendet werden, deren räumlicher Gradient der z-Komponente zu mindestens einem Zeitpunkt der Einstrahlung nicht konstant ist, und dass die einzustrahlenden Hochfrequenzpulse vorab berechnet werden, wobei im Bereich des Objekts zeitliche Verläufe der Feldstärken der Zusatzmagnetfelder, welche ortsabhängig berechnet und/oder gemessen werden, explizit in diese Berechnung eingehen.

Bei dem erfindungsgemäßen Verfahren werden zur ortsabhängigen Änderung der Magnetisierung gemäß einer Vorgabe dieser Änderung, Hochfrequenzpulse in Kombination mit räumlich und zeitlich variierenden Zusatzmagnetfeldern, die dem statischen und homogenen Grundfeld der Magnetresonanzmessapparatur, welches die z-Richtung im Raum auszeichnet, eingestrahlt. Hierbei werden Zusatzmagnetfelder eingesetzt, deren räumlicher Gradient der z-Komponente zu mindestens einem Zeitpunkt der Einstrahlung nicht konstant ist. Die Berechnung der Hochfrequenzpulse kann daher nicht wie in den bisher offengelegten Verfahren durchgeführt werden, welche einen linearen räumlichen Verlauf der Zusatzmagnetfelder annehmen, so dass sich deren Wirkung über das Durchlaufen einer Trajektorie im k-Raum beschreiben lässt. Bei dem erfindungsgemäßen Verfahren erfolgt die Berechnung der Hochfrequenzpulse hingegen auf der Basis von ortsabhängig berechneten und/oder gemessenen zeitlichen Verläufen der Zusatzmagnetfelder im Bereich des Objektes.

Es kann vorteilhaft sein, bei der Ermittlung der ortsabhängigen zeitlichen Verläufe der Zusatzmagnetfeldstärken im Bereich des Objektes auf eine Kombination von Berechnung und Messung zurückzugreifen. So kann beispielsweise der Beitrag eines Zusatzmagnetfeldes, welches während der Einstrahlung seinen räumlichen Verlauf beibehält und lediglich in seiner globalen Amplitude variiert wird, dadurch ermittelt werden, indem der räumliche Verlauf bei einer festen Amplitude in einem separaten Vorexperiment gemessen wird und dieser gemessene Verlauf - zur Ermittlung des räumlichen und zeitlichen Verlaufs des Zusatzmagnetfeldes - mit dem durch die Sequenzsteuereinheit der Magnetresonanzmessapparatur vorgegebenen zeitlichen Verlauf der Amplitude skaliert wird. Eine solche kombinierte Ermittlung aus Berechnung und Messung kann beispielsweise deutlich zeitsparender sein als eine vollständig messungsbasierte Ermittlung des räumlichen und zeitlichen Verlaufs der Zusatzmagnetfeldstärken.

Bevorzugte Ausführungsformen der Erfindung

Varianten sowie weitere vorteilhafte Eigenschaften und Ausgestaltungen der Erfindung sind im Folgenden beschrieben.

Im Rahmen des erfindungsgemäßen Verfahrens soll auch eine eindeutige Sendeortskodierung im Bereich des gesamten Objektes ermöglicht werden.

In einer besonders bevorzugten Variante des erfindungsgemäßen Verfahrens kommen Zusatzmagnetfelder zum Einsatz, die so beschaffen sind, dass bei Verwendung einer einzigen HF-Sendeantenne, deren Sendeprofil das ganze Objekt abdeckt, innerhalb des Objektes im Rahmen der SDMM zwangsläufig mindestens eine Gruppe von äquivalenten Orten auftritt. Diese zeichnen sich dadurch aus, dass an ihnen die Änderung der Magnetisierung - auch bei beliebig hoher Ortsauflösung - nicht unabhängig voneinander durchgeführt werden kann. Das einfachste Beispiel hierfür ist, dass es mehrere Orte in verschiedenen Regionen des Untersuchungsobjektes gibt, an welchen der zeitliche Feldverlauf der Superposition der Zusatzmagnetfelder identisch ist. In diesem Fall würde ein HF-Puls, welcher an diesen Orten dieselben zeitlichen HF-Feldverläufe erzeugt, wie es beispielsweise bei der Einstrahlung mit einer räumlich homogenen Sendespule der Fall ist, dieselbe Änderung der Magnetisierung erzeugen, sodass nur sehr spezielle Magnetisierungsmuster, deren Symmetrien denen der Zusatzmagnetfelder entsprechen, realisierbar wären. Aber auch für den Fall, dass der zeitliche Feldverlauf der Superposition der Zusatzmagnetfelder an einem Ort einer solchen Gruppe noch um beispielsweise einen zeitlich konstanten Betrag von dem eines anderen abweicht, ist die Änderung der Magnetisierung an diesem Ort nicht unabhängig von den anderen Orten der Gruppe durchführbar.

Um zu erreichen, dass dennoch die Änderung der Magnetisierung an mindestens einem Ort einer Gruppe unabhängig von den anderen Orten der Gruppe durchgeführt werden kann, werden mindestens zwei HF-Sendeantennen verwendet, die durch ihre unterschiedlichen Sendeprofile im Bereich des Objektes zur Ortskodierung beitragen. Dadurch kann eine zumindest partielle Differenzierung zwischen äquivalenten Orten bei der SDMM erreicht werden.

In einer weiteren vorteilhaften Variante des erfindungsgemäßen Verfahrens sind die Zusatzmagnetfelder so beschaffen, dass die Änderung der Magnetisierung mit räumlich variierender Auflösung erfolgen kann. Dies ist beispielsweise dann nützlich, wenn die Zusatzmagnetfelder nur an bestimmten, für die MR-Untersuchung interessanten Orten des Objektes eine Änderung der Magnetisierung mit höherer Auflösung erlauben, während an weniger interessanten Orten nur eine geringe Auflösung möglich ist, und wenn die Zusatzmagnetfelder insgesamt eine geringere maximale Feldstärke aufweisen als lineare Zusatzmagnetfelder, welche die höhere Auflösung im ganzen Objekt ermöglichen. Diese geringere maximale Feldstärke kann dazu beitragen, die technischen Anforderungen an das die Zusatzmagnetfelder erzeugende Gradientensystem zu reduzieren oder die Gefahr einer peripheren Nervenstimulation durch sich zu stark ändernde Zusatzmagnetfelder zu verringern.

Eine sehr nützliche Variante des erfindungsgemäßen Verfahrens besteht darin, die Vorgabe der ortsabhängigen Änderung der Magnetisierung so zu wählen, dass das erfindungsgemäße Verfahren nur in einer oder mehreren Regionen innerhalb des Objektes eine nichtverschwindende Änderung der Magnetisierung bewirkt. Dies kann beispielsweise dazu verwendet werden, im Rahmen einer räumlich selektiven Anregung nur an bestimmten Orten Transversalmagnetisierung aus der anfänglichen Longitudinalmagnetisierung zu erzeugen.

In diesem Zusammenhang kann es vorteilhaft sein, die Region/en an anatomische, morphologische oder funktionelle Gegebenheiten des Untersuchungsobjekts anzupassen, so dass auf diese Weise u. a. bestimmte Regionen des Untersuchungsobjektes, die zu Störungen der Messung führen können, von der Anregung ausgeschlossen werden können.

Wird zur Datenaufnahme ein lokales Gradientensystem verwendet, das keine eindeutige Ortskodierung im gesamten Objekt erlaubt, können beispielsweise bei der räumlich selektiven Anregung nur solche Region/en angeregt werden, deren Vereinigung bei der Datenakquisition eindeutig ortskodiert werden kann.

Besonders nützlich ist auch eine weitere Variante des erfindungsgemäßen Verfahrens, die sich dadurch auszeichnet, dass die Phase der Transversalmagnetisierung entsprechend einer vorgegebenen räumlichen Verteilung geändert wird. Dies kann z. B. vorteilhaft zur Vorkompensation von suszeptibilitätsbedingten Dephasierungen des MR-Signals während eines Bildgebungsexperiments und damit zur Abschwächung von Signalverlusten eingesetzt werden, indem das zur Phasenkompensation verwendete Phasenmuster, d. h die räumliche Phasenverteilung der Transversalmagnetisierung, vorab aus den Parametern des Bildgebungsexperiments berechnet wird.

Diese Verfahrensvariante kann noch dadurch weitergebildet werden, dass im Rahmen eines Experimentes der magnetischen Resonanz die Änderung der räumlichen Verteilung der Phasen der Transversalmagnetisierung wiederholt in mindestens zwei sog. Phasenkodierperioden entsprechend einem Ortskodierschema erfolgt, dass nach jeder dieser Phasenkodierperioden eine Datenaufnahme vorgenommen wird, und dass die Gesamtheit der so aufgenommenen Daten dem Ortskodierschema entsprechend ortsaufgelöst rekonstruiert und abgespeichert und/oder bildhaft dargestellt wird..Bei dieser Variante wird die Änderung von Phasenmustern der transversalen Magnetisierung dazu verwendet, eine teilweise oder vollständige Ortskodierung der Magnetresonanzsignale während der Änderung der Magnetisierung zu erzielen. Durch wiederholte Änderung in mehreren Phasenkodierperioden mit unterschiedlichen, gemäß einem Phasenkodierschema festgelegten Phasenmustern und jeweils nachfolgender Datenaufnahme wird ein Gesamtdatensatz gewonnen, der dann dem Ortskodierschema entsprechend ortsaufgelöst rekonstruiert wird und z. B. zwei- oder dreidimensionale Bilder des Untersuchungsobjekts liefert. Weitere Vorteile dieser Variante sind identisch mit in [16] beschriebenen Vorzügen (z. B. direkte Aufnahmen von FIDs, Verwendung von prinzipiell identischen Gradientenpulsen in allen Phasenkodierperioden, räumliche Variation der Ortsauflösung), da sich das in [16] beschriebene Verfahren im Wesentlichen dadurch von der hier beschriebenen Variante unterscheidet, dass es auf der Beschreibung der Zusatzmagnetfelder als k-Raum-Trajektorie beruht.

Diese Variante ist ein Beispiel dafür, dass mit dem erfindungsgemäßen Verfahren Verteilungen der Amplitude und/oder Phase der transversalen Magnetisierung erzeugt werden können, die - unabhängig von der Aufteilung des Untersuchungsvolumens in Bereiche mit unterschiedlichen Magnetfeldverläufen, z.B. Zusammensetzung des Untersuchungsvolumens aus mehreren MSEMS, - ein durchgängiges Muster für das gesamte Untersuchungsvolumen aufweisen. Diese Variante erlaubt es z. B., für das gesamte Untersuchungsvolumen oder ein darin enthaltenes beliebiges Abbildungsvolumen eine Ortskodierung der MR-Signale so vorzunehmen, dass die Bildrekonstruktion mit einer einfachen klassischen Fouriertransformation erfolgen kann, ohne die Besonderheiten der verwendeten nicht-linearen Zusatzmagnetfelder bei der Rekonstruktion berücksichtigen zu müssen.

Detaillierte Beschreibung der Erfindung

In herkömmlichen Verfahren zur ortsabhängigen Änderung der Magnetisierung in einem Untersuchungsobjekt werden stets Zusatzmagnetfelder mit einem linearen räumlichen Verlauf innerhalb des Objekts vorausgesetzt, was beispielsweise in [1], Gleichungen 1 und 7, durch die Darstellung des Zusatzmagnetfeldes als Produkt $\mathbf{G}(t)\cdot\mathbf{r} = \Delta B_0(t,\mathbf{r})$, also des räumlich konstanten, da ortsunabhängigen, Gradienten $\mathbf{G}(t)$ mit der Ortskoordinate $\mathbf{r}$ selbst, deutlich wird. In spezielleren herkömmlichen Verfahren, die auf die räumlich selektive Anregung im Kleinwinkelregime eingeschränkt sind, siehe z.B. [6], ist diese Voraussetzung ebenfalls notwendig, siehe dort Gleichung 1. Die Eigenschaft des konstanten Gradienten wird in diesen Verfahren weiterhin verwendet, um den Begriff des "k-Raums im Sendefall" einzuführen (siehe ebendort Gl. 7 und 8), welcher vom üblichen k-Raum im Empfangsfall leicht abweicht. Bei gegebenem zeitlichem Verlauf des Gradienten wird die k-Raum Koordinate im Sendefall definiert durch

$$\mathbf{k}(t) = -\gamma \int_t^T dt' \, \mathbf{G}(t') \quad , \tag{1}$$

wobei $T$ die Gesamtdauer der Anwendung der Zusatzmagnetfelder und $\gamma$ das gyromagnetische Verhältnis des untersuchten Kerns bezeichnen. Mit dieser Definition lässt sich die Phase, die die zum Zeitpunkt $t$ erzeugte infinitesimale Transversalmagnetisierung bis zum Ende der Anwendung der Zusatzmagnetfelder noch von diesen Feldern aufgeprägt bekommt, als Funktion des linearen Produkts $\mathbf{k}(t)\cdot\mathbf{r}$ schreiben und eine Designgleichung

$$M_{\mathrm{xy}}(\mathbf{r}) = i\gamma M_0(\mathbf{r}) \int_0^T dt \, B_1(t) \exp[i(\mathbf{k}(t)\cdot\mathbf{r})] \tag{2}$$

ableiten (siehe auch ebendort Gl. 13). Die herkömmlichen Kleinwinkelverfahren operieren stets mit Designgleichungen, die Gleichung (2) ähnlich sind, und damit mit dem Begriff des k-Raums im Sendefall. Dieser Begriff ist jedoch ausschließlich für global konstante Gradienten definierbar, daher sind die herkömmlichen Pulsberechnungsmethoden für eine Änderung der Magnetisierung unter Anwendung von Zusatzmagnetfeldern, deren räumlicher Gradient zu mindestens einem Zeitpunkt nicht konstant ist, nicht geeignet.

Es ist vorstellbar, dass zur Umgehung dieser Problematik ein lokaler k-Raum-Begriff, der nur für eingeschränkte Bereiche im Abbildungsbereich gültig ist, eingeführt werden könnte, jedoch ist die für die erfindungsgemäße Ausführung der ortsabhängigen Änderung der Magnetisierung erforderliche HF-Pulsberechnung eine direktere Lösung, wie im folgenden dargestellt.

Zunächst wird hier ein Beispiel beschrieben, wie die erfindungsgemäße Pulsberechnung für den Bereich kleiner Veränderungswinkel (<15°) durchgeführt werden kann. Die Phase $\varphi$, die die zum Zeitpunkt $t$ erzeugte infinitesimale Transversalmagnetisierung (in der üblichen Kleinwinkelnäherung) bis zum Ende der Anwendung der Zusatzmagnetfelder noch von diesen Feldern aufgeprägt bekommt, erfolgt nach dem erfindungsgemäßen Verfahren explizit aus den allgemeinen räumlichen und zeitlichen Verläufen der Zusatzmagnetfelder $F_j(t,\mathbf{r})$ als

$$\varphi(t,\mathbf{r}) = -\gamma \int_t^T dt' \sum_j F_j(t,\mathbf{r}) \qquad (3)$$

Damit ergibt sich die folgende Designgleichung im Kleinwinkelregime

$$M_{xy}(\mathbf{r}) = i\gamma M_0(\mathbf{r}) \int_0^T dt \sum_l S_l(\mathbf{r}) I_l(t) \exp[-i\gamma \int_t^T dt' \sum_j F_j(t',\mathbf{r})] \qquad (4)$$

Hierbei sind $S_l(\mathbf{r})$ die Sendeprofile der zur HF-Pulsform $I_l(t)$ gehörigen HF-Sendeantenne. Weiterhin bezeichnet $\mathbf{r}$ die Ortsvariable, $t$ die Zeitvariable, $M_O(\mathbf{r})$ die ortsabhängige Ausgangsmagnetisierung, $\gamma$ das gyromagnetische Verhältnis des untersuchten Kerns, $T$ die Gesamtdauer des längsten HF-Pulses und der Anwendung der Zusatzmagnetfelder und $M_{xy}(\mathbf{r})$ die ortsabhängige transversale Zielmagnetisierung. Die Vorgabe einer Zielmagnetisierung ist in diesem Fall äquivalent zur Vorgabe einer ortsabhängigen Änderung der Magnetisierung, da die Ausgangsmagnetisierung definiert ist.

Die Lösung der Designgleichung (4) nach den HF-Pulsformen $I_l(t)$ erfolgt nach Diskretisierung und Umwandlung in ein quadratisches Minimierungsproblem numerisch mit dem allgemein bekannten Conjugate Gradient Verfahren.

Dieses Verfahren zur ortsabhängigen Änderung der Magnetisierung, wobei die beschriebenen HF-Pulse und Zusatzmagnetfelder angewendet werden, unterscheidet sich von einem bereits existierenden Verfahren zur ortsabhängigen Änderung der Magnetisierung anhand gemessener Phasenverläufe $\varphi(t,\mathbf{r})$ [13,14] insbesondere dadurch, dass letzteres auf experimentell gemessenen Phasenverläufen beruht, wohingegen das vorliegende Verfahren auf räumlichen und zeitlichen Verläufen der Zusatzmagnetfelder $\Delta B_0(t,\mathbf{r})$ definiert ist, insbesondere falls diese als Produkt von statisch gemessenen oder simulierten räumlichen Feldverläufen mit vorgegebenen zeitlichen Verläufen gemäß

$$\Delta B_0(t,\mathbf{r}) = \sum_j F_j(\mathbf{r}) A_j(t) \qquad (5)$$

berechnet werden können.

Nun wird beispielhaft eine mögliche Variante für die zur Ausführung des erfindungsgemäßen Verfahrens erforderliche HF-Pulsberechnung für den Bereich beliebiger Veränderungswinkel beschrieben. Dafür wird zunächst wie oben beschrieben ein Kleinwinkel HF-Puls berechnet, indem die ortsabhängige Zielmagnetisierung geeignet angepasst wird. Der resultierende HF-Puls, d. h die Gesamtheit der HF-Pulsformen für alle HF-Sendeantennen, wird nun mit dem Faktor skaliert, der dem Verhältnis zwischen dem gewünschten beliebigen Veränderungswinkel der Magnetisierung und dem angenommenem Veränderungswinkel der Magnetisierung bei der Kleinwinkelberechnung (<15°) entspricht. Der skalierte HF-Puls ist der Ausgangspunkt für die folgende iterative Optimierung mittels Optimal Control.

In diesem Verfahren wird die Blochsche Gleichung iterativ gelöst und in jeder Iteration die HF-Pulsformen verbessert, in dem Sinne, dass die kombinierte Anwendung der Zusatzmagnetfelder und der HF-Pulse eine Änderung der ortsabhängigen Magnetisierung bewirken, die der Zielvorgabe immer näher kommt.

Die Integration der Blochschen Gleichung für die Magnetisierung an jedem Ort $\mathbf{r}$

$$\begin{pmatrix} \dot{M}_x(t,\mathbf{r}) \\ \dot{M}_y(t,\mathbf{r}) \\ \dot{M}_z(t,\mathbf{r}) \end{pmatrix} = \gamma \begin{pmatrix} 0 & \Delta B_0(t,\mathbf{r}) & -B_{1,y}(t,\mathbf{r}) \\ -\Delta B_0(t,\mathbf{r}) & 0 & B_{1,x}(t,\mathbf{r}) \\ B_{1,y}(t,\mathbf{r}) & -B_{1,x}(t,\mathbf{r}) & 0 \end{pmatrix} \cdot \begin{pmatrix} M_x(t,\mathbf{r}) \\ M_y(t,\mathbf{r}) \\ M_z(t,\mathbf{r}) \end{pmatrix} \qquad (6)$$

erfolgt ausgehend vom Ausgangszustand der Magnetisierung für die gesamte Dauer der Anwendung der Zusatzmagnetfelder und der HF-Pulse von $t=0$ bis $t=T$. Hierbei sind $B_{1,x}(t,\mathbf{r})$ und $B_{1,y}(t,\mathbf{r})$ Real- und Imaginärteil des Sendefeldes. Der Verlauf der Zusatzmagnetfelder als Produkt $\mathbf{G}(t)\cdot\mathbf{r} = \Delta B_0(t,\mathbf{r})$ aus dem Stand der Technik ist hier nicht geeignet, weswegen erfindungsgemäß der räumliche und zeitliche Verlauf der Zusatzmagnetfelder $\Delta B_0(t,\mathbf{r})$ direkt in die Blochsche Gleichung (6) eingeht. In einer Variante des erfindungsgemäßen Verfahrens kann dieser Verlauf $\Delta B_0(t,\mathbf{r})$ aus simulierten und/oder gemessenen räumlichen Zusatzmagnetfeldverläufen und vorgegebenen zeitlichen Verläufen nach Gleichung (5) gewonnen werden.

Die Integration der Blochschen Gleichung liefert die theoretisch resultierende ortsabhängige Magnetisierung bei Anwendung der Zusatzmagnetfelder und des HF-Pulses der jeweiligen Iteration. Diese resultierende Magnetisierung wird in jeder Iteration mit der durch die Vorgabe der Änderung definierten Zielmagnetisierung verglichen. Bei Unterschreiten eines gegebenen, geeignet gewählten, Maßes der Abweichung wird die Iteration abgebrochen, womit der geforderte HF-Puls als Gesamtheit der HF-Pulsformen für alle Sendeantennen gefunden ist.

Hat die Abweichung $\lambda_i$ in der i-ten Iteration das gewählte Kriterium noch nicht erfüllt, wird die Blochsche Gleichung für $\lambda(t,\mathbf{r})$ anstelle für die volle ortsabhängige Magnetisierung integriert, mit einer Anfangsbedingung zum Zeitpunkt $T$ von $\lambda(T,\mathbf{r}) = \lambda_i$. Die Integration verläuft daher von $t=T$ bis $t=0$. In diesem Schritt wird wiederum die Blochgleichung mit der erfindungsgemäßen Ermittlung der Zusatzmagnetfelder verwendet.

Gemäß den Prinzipien der Variationsrechnung werden dann aus den berechneten Verläufen $\mathbf{M}(t,\mathbf{r})$, $\lambda(t,\mathbf{r})$ und $I_l(t)$ und den Sendeprofilen verbesserte Großwinkel-HF-Pulsformen $I_l(t)^{\text{opt}}$ nach

$$I_l(t)^{\text{opt}} = I_l(t) - \mu \sum_{\mathbf{r}} \lambda(t,\mathbf{r})^{\mathsf{T}} \bullet \begin{pmatrix} 0 & 0 & -iS_l^*(\mathbf{r}) \\ 0 & 0 & S_l^*(\mathbf{r}) \\ iS_l^*(\mathbf{r}) & -S_l^*(\mathbf{r}) & 0 \end{pmatrix} \bullet \mathbf{M}(t,\mathbf{r}) \qquad , \qquad (7)$$

gewonnen, wobei eine Schrittweite $\mu$ geeignet gewählt wird. Mit den verbesserten HF-Pulsformen $I_l(t)^{\text{opt}}$ wird die Iteration bei der Vorwärtsintegration der Blochschen Gleichung fortgesetzt.

In einer Variante des erfindungsgemäßen Verfahrens entstehen durch die Verwendung nichtlinearer Zusatzmagnetfelder äquivalente Orte, welche dadurch gekennzeichnet sind, dass an ihnen die Magnetisierung allein anhand des Verlaufs der Zusatzmagnetfelder und unter Verwendung einer Sendeantenne mit einem das gesamte Objekt abdeckenden Sendeprofil nicht unabhängig voneinander veränderbar ist, z. B. falls dort der Verlauf der Superposition der Zusatzmagnetfelder identisch ist. Das erfindungsgemäße Verfahren ermöglicht, mindestens teilweise, die unabhängige Änderung der Magnetisierung an diesen Orten durch die Verwendung mehrerer Sendeantennen mit räumlich unterschiedlichen Sendeprofilen durch das Senden unabhängiger HF-Pulsformen auf diesen Antennen und die folglich unterschiedlichen Sendefelder an den äquivalenten Orten.

## Zeichnung und detaillierte Beschreibung eines Ausführungsbeispiels

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand eines Ausführungsbeispiels näher erläutert.

Es zeigen:

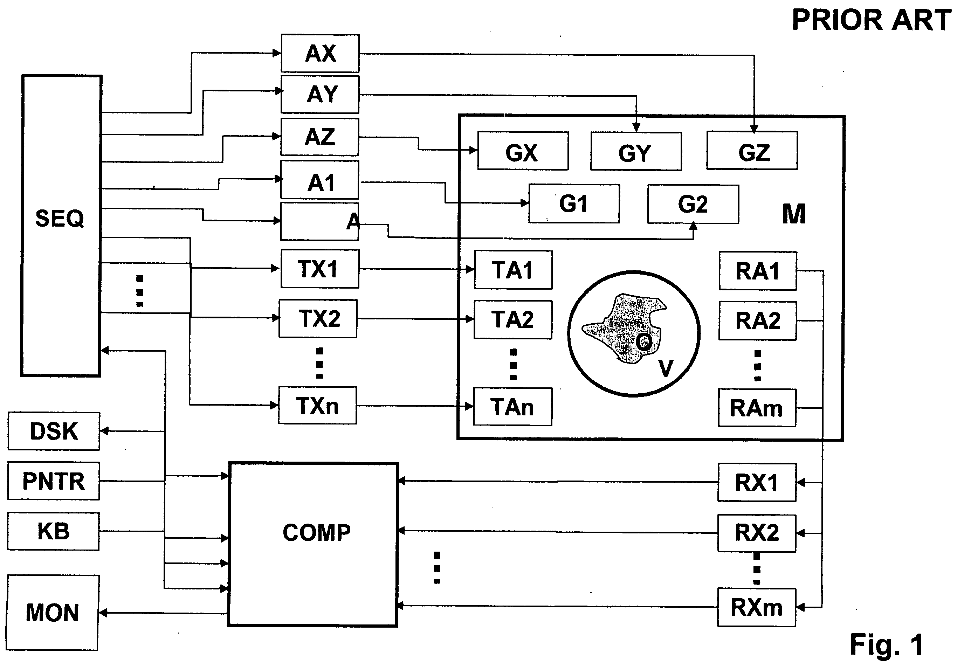

Fig. 1    eine schematische Darstellung einer zur Durchführung des erfindungsgemäßen Verfahrens geeigneten MR-Messapparatur nach dem Stand der Technik;

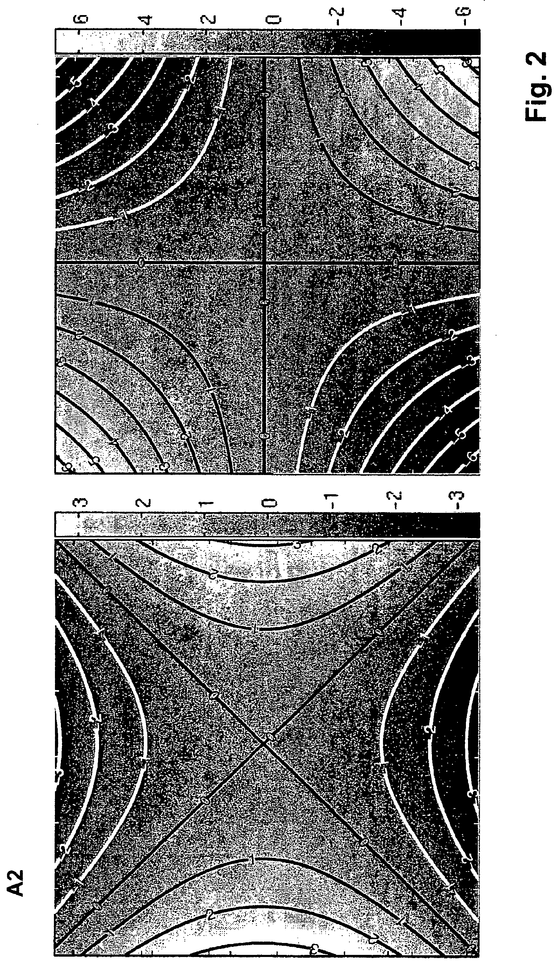

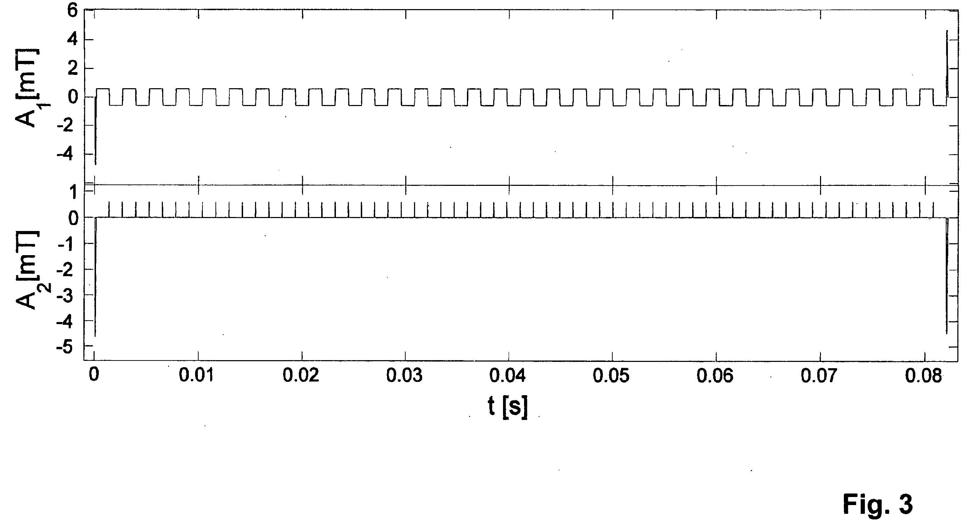

Fig. 2    den räumlichen Verlauf der z-Komponente zweier Zusatzmagnetfelder $F_1$ und $F_2$ in einer Schnittebene des Objektes, die während des Sendens angewendet werden und deren Gradienten der z-Komponente nicht konstant sind. Die Amplitude der Felder ist in relativen Einheiten angegeben und wird gemäß der in Fig. 3 dargestellten Amplitudengewichtung als Funktion der Zeit skaliert. Der dargestellte Bereich hat eine Größe von 6 cm x 6 cm.

Fig. 3    den zeitlichen Verlauf $A_1$ und $A_2$ der Maximalamplituden der Zusatzmagnetfelder aus Fig. 2 während der Anwendung der HF-Pulse. Der räumliche Verlauf der Zusatzmagnetfelder ergibt sich relativ zu dieser Maximalamplitude wie in Fig. 2 dargestellt.

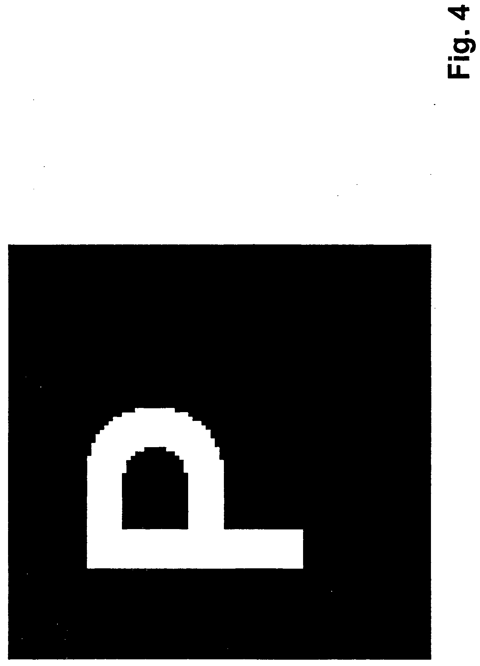

Fig. 4    die Zielverteilung der x-Komponente für die ortsabhängige Änderung der Magnetisierung in einer Schnittebene des Objektes. Die räumliche Ausdehnung der dargestellten Verteilung beträgt 6 cm x 6 cm. Der weiß dargestellte Bereich entspricht einer geforderten reinen x-Magnetisierung, während schwarz dargestellte Bereiche eine geforderte reine z-Magnetisierung repräsentieren.

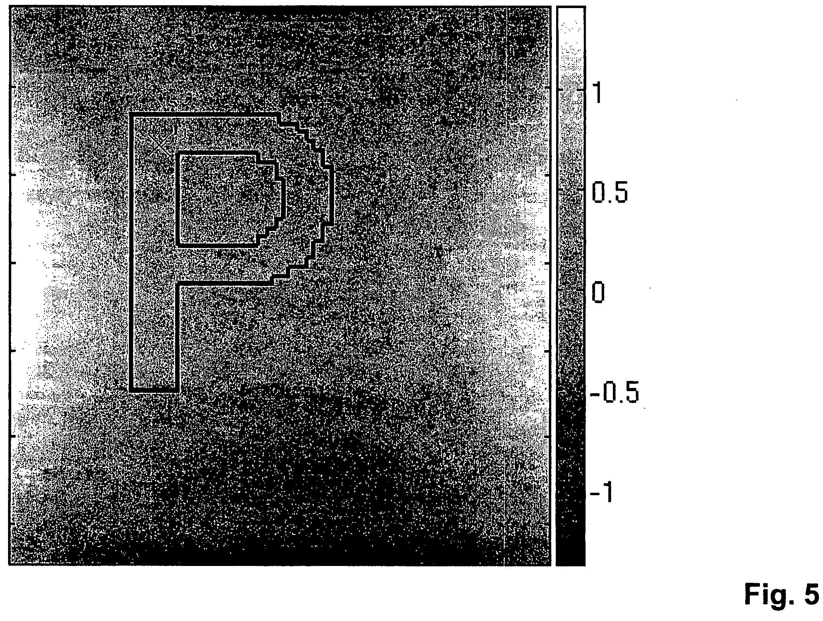

Fig. 5    zwei äquivalente Orte $\mathbf{r}_1$ und $\mathbf{r}_2$, gekennzeichnet durch schwarze Kreuze überlagert dem Zusatzmagnetfeld

$F_1$. Ein entsprechendes Bild ergibt sich für $F_2$. Die schwarze Überlagerung des Umrisses der ortsabhängigen Zielmagnetisierung verdeutlicht, dass an den beiden äquivalenten Orten verschiedene Magnetisierungen gefordert sind.

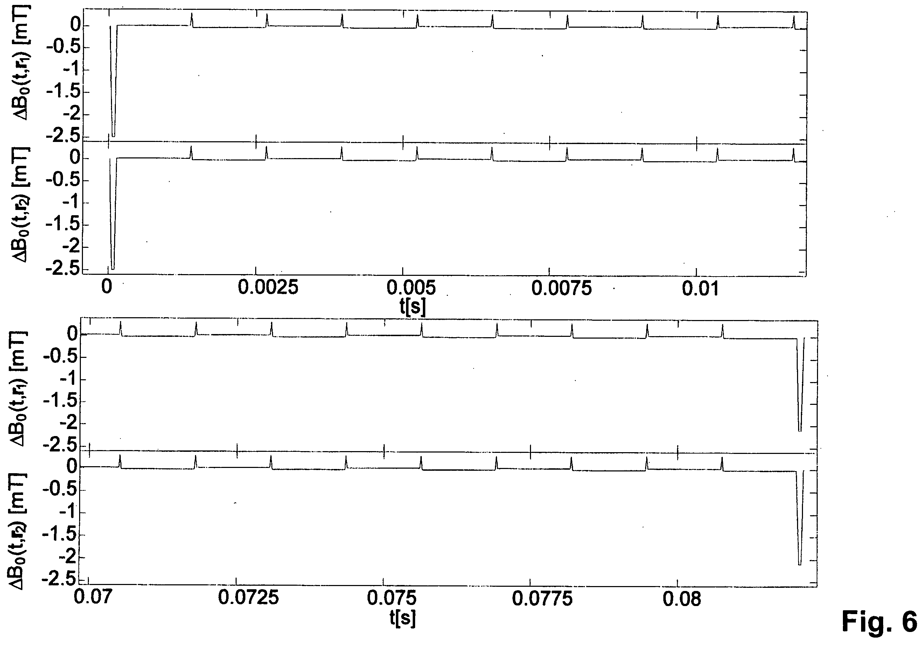

Fig. 6 die Zusatzmagnetfeldstärke $\Delta B_0(t,\mathbf{r})$ an den äquivalenten Orte $\mathbf{r}_1$ und $\mathbf{r}_2$ (siehe Fig. 5) als Funktion der Zeit. Der Übersicht halber sind die Zusatzmagnetfeldstärken nur beispielhaft zu Beginn und am Ende der Anwendung dargestellt. Durch die Punktsymmetrie der beiden Zusatzmagnetfelder $F_1$ und $F_2$ ist der gesamte Verlauf der Zusatzmagnetfeldstärke identisch an den beiden äquivalenten Orten.

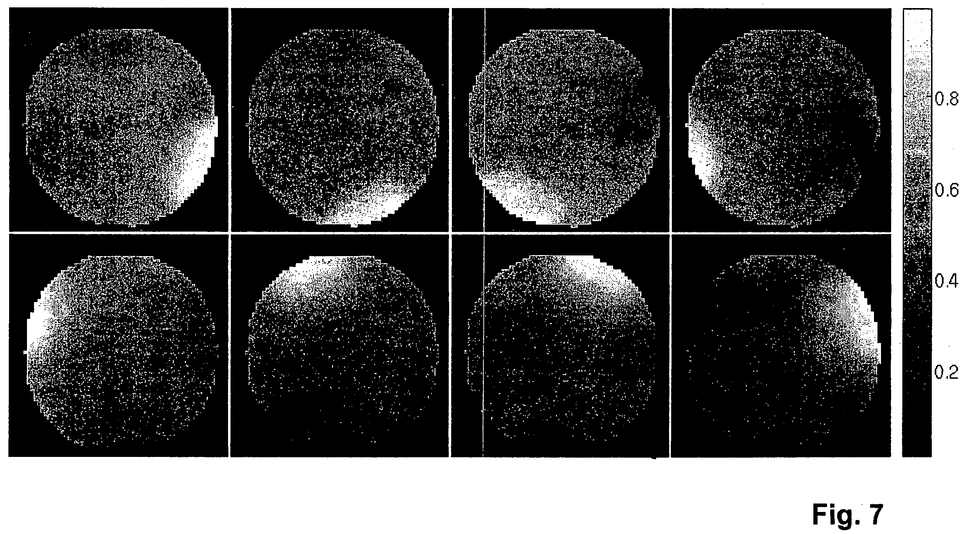

Fig. 7 die relativen Amplituden der räumlichen Sendeprofile der 8 Sendeantennen, die in die Mehrkanalpulsberechnung eingehen. Die ausgeprägte räumliche Lokalisierung der Sendeprofile ermöglicht die räumliche Unterscheidbarkeit äquivalenter Orte, die wie im vorliegenden Beispiel durch die Verwendung nichtlinearer Zusatzmagnetfelder zustande kommen können.

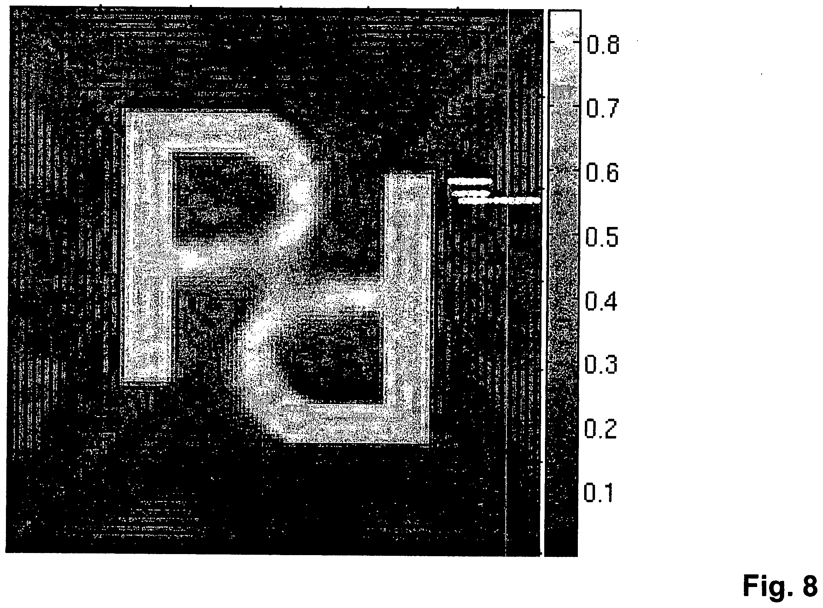

Fig. 8 das Ergebnis der Simulation der veränderten ortsabhängigen Magnetisierung nach Anwendung der Zusatzmagnetfelder mit nichtkonstantem Gradienten und nur einer Sendeantenne mit homogenem räumlichem Sendeprofil. Als Folge der Existenz äquivalenter Orte ist signifikante Transversalmagnetisierung an weiteren Orten als an den Orten, die von der Zielverteilung vorgegeben wurde (siehe Fig. 4) entstanden, und der Betrag der Transversalmagnetisierung ist kleiner, als in der Zielverteilung gefordert.

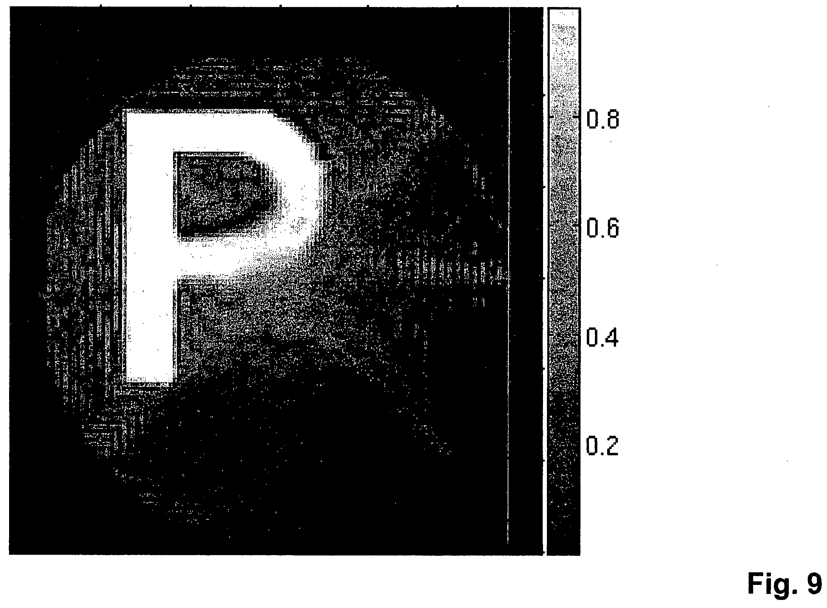

Fig. 9 das Ergebnis der Simulation der veränderten ortsabhängigen Magnetisierung entsprechend dem erfindungsgemäßem Verfahren nach Anwendung der Zusatzmagnetfelder mit nichtkonstanten Gradienten und HF-Pulsen durch acht Sendeantennen mit verschiedenen räumlichen Sendeprofilen. Durch die Verwendung mehrerer Sendeantennen kann die gewünschte ortsabhängige Magnetisierung hinreichend genau realisiert werden.

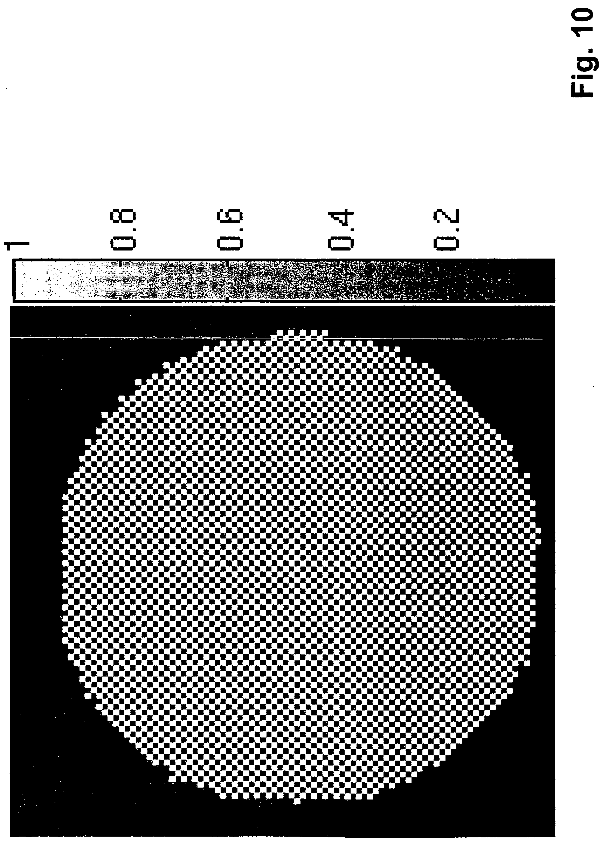

Fig. 10 die Zielverteilung der x-Komponente der Magnetisierung zur Evaluation des Auflösungsvermögens des erfindungsgemäßen Verfahrens im Vergleich mit dem Stand der Technik. Auf der räumlichen Ausdehnung von 6 cm x 6 cm sind Punkte mit alternierender Zielmagnetisierung im Abstand von 6/92 cm in jeder Richtung platziert. Weiße Bereiche entsprechen einer geforderten reinen x-Magnetisierung, während schwarze Bereiche eine geforderte reine z-Magnetisierung repräsentieren.

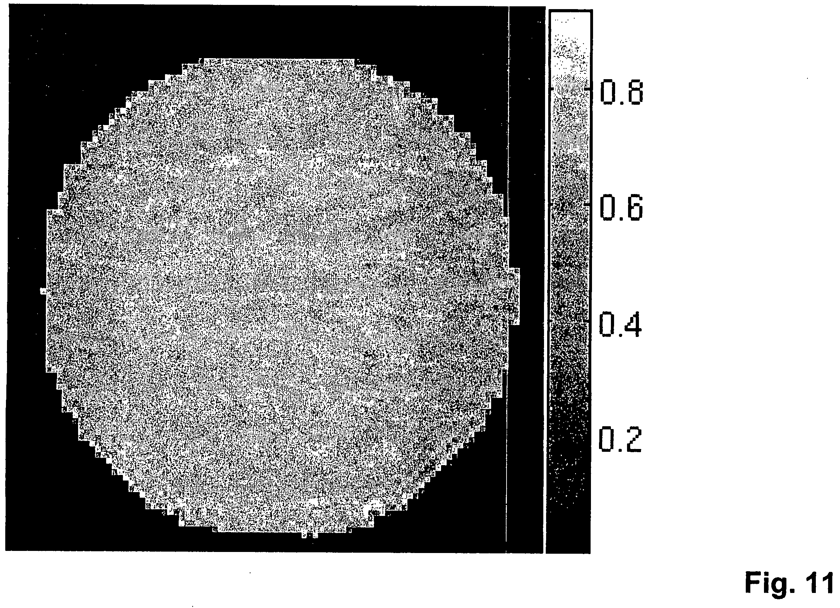

Fig. 11 das Ergebnis der Simulation der veränderten ortsabhängigen Magnetisierung durch einen HF-Puls nach Stand der Technik mit acht Sendeantennen und unter Verwendung konventioneller Zusatzmagnetfelder mit konstantem Gradienten, deren Verlauf so gewählt ist, dass die Auflösung der Zielverteilung in Fig. 10 nicht möglich ist. Dies ist an der räumlich verhältnismäßig homogenen Magnetisierung ersichtlich.

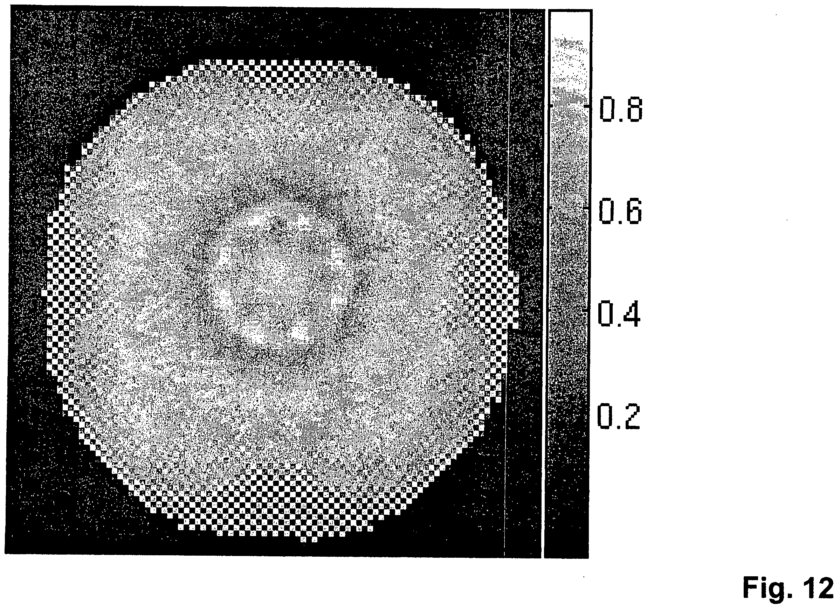

Fig. 12 das Ergebnis der Simulation der veränderten ortsabhängigen Magnetisierung durch einen HF-Puls nach dem erfindungsgemäßen Verfahren unter Verwendung der in Fig. 2 dargestellten Zusatzmagnetfelder, deren Maximalamplitude im Objekt mit der Maximalamplitude der konventionellen Zusatzmagnetfelder aus dem Verfahren nach Stand der Technik übereinstimmt. Es ist ersichtlich, dass im Gegensatz zu Fig. 11 die Zielmagnetisierung in den äußeren Bereichen des zweidimensionalen Objekts realisiert werden kann und dass das Auflösungsvermögen gemäß Anspruch 3 räumlich variiert.

In Fig. 1 ist schematisch eine MR-Messapparatur dargestellt, die zur Durchführung des erfindungsgemäßen Verfahrens geeignet ist. Die Apparatur enthält einen Hauptmagneten **M**, mit welchen das in einem Untersuchungsvolumen **V** im Wesentlichen homogene und statische Grundmagnetfeld erzeugt wird. Der Teil des zu untersuchenden Objekts, der im Untersuchungsvolumen enthalten ist, wird im Folgenden als Untersuchungsobjekt oder kurz als Objekt O bezeichnet. Das Untersuchungsvolumen V umgebend, sind in die Bohrung des Hauptmagneten M ein globales Gradientensystem, bestehend aus drei Sätzen von Gradientenspulen **GX**, **GY** und **GZ**, sowie ein lokales Gradientensystem eingebracht, mit welchem durch Schalten von in der Regel mehreren Spulen zu Spulenkombinationen **G1**, **G2**, ... verschiedene Ausprägungen von lokalen Zusatzmagnetfeldern, den lokalen Gradienten, realisiert werden können. Globales und lokales Gradientensystem müssen nicht als getrennte Instrumente realisiert sein, sondern können unter Umständen auf gemeinsame Gradientenspulen zurückgreifen. In Fig. 1 sind beispielhaft zwei solcher Spulenkombinationen, G1 und G2, dargestellt. Mit beiden Gradientensystemen können Zusatzmagnetfelder kontrollierbarer Dauer und Stärke dem Grundfeld überlagert werden. Mit Gradientenverstärkern **AX**, **AY**, **AZ**, **A1** und **A2**, die von einer Sequenzsteuereinheit **SEQ** zur zeitrichtigen Erzeugung von Gradientenpulsen angesteuert werden, werden die Gradientenspulensätze GX, GY, GZ, G1 und G2 mit elektrischem Strom zur Erzeugung der Zusatzfelder versorgt.

Innerhalb des Gradientsystems befinden sich mehrere Sendeelemente **TA1** bis **TA**n, die in ihrer Gesamtheit auch als Sendeantenneneinrichtung bezeichnet werden. Sie umgeben das Untersuchungsobjekt **O** und werden von mehreren unabhängigen HF-Leistungssendern **TX1 ... TX**n gespeist. Die von diesen HF-Leistungssendern TX1 ... TXn erzeugten HF-Pulse werden von der Sequenzsteuereinheit SEQ bestimmt und zeitrichtig ausgelöst. Mit den Sendeelementen TA1 bis TAn werden HF-Pulse auf das im Untersuchungsvolumen V befindliche Untersuchungsobjekt O eingestrahlt und bewirken dort eine Anregung von Kernspins. Die dadurch hervorgerufenen Magnetresonanzsignale werden mit einer oder mehreren HF-Empfangselementen **RA1,..., RA**m in elektrische Spannungssignale umgesetzt, die dann in eine entsprechende Anzahl von Empfangseinheiten **RX1,..., RX**m eingespeist werden. Die Empfangselemente **RA1,..., RA**m werden in ihrer Gesamtheit auch als Empfangsantenneneinrichtung, bestehend aus m Empfangselementen RA1,..., RAm, bezeichnet. Sie befinden sich ebenfalls innerhalb der Gradientenspulen GX, GY, GZ und umgeben das Untersuchungsobjekt O.

Zur Verringerung des apparativen Aufwandes können die Sende- und Empfangsantenneneinrichtungen auch so ausgelegt und angeschlossen werden, dass ein oder mehrere der Sendeelemente TA1 bis TAn auch zum Empfang der Magnetresonanzsignale genutzt werden. In einem solchen Fall, der in Fig. 1 nicht berücksichtigt ist, wird mittels einer bzw. mehrerer von der Sequenzsteuereinheit SEQ kontrollierter elektronischer Sende-Empfangsweichen für eine Umschaltung zwischen Sende- und Empfangsbetrieb gesorgt, d. h. dass während der HF-Sende-Phasen der ausgeführten Pulssequenz diese Antenne(n) mit dem bzw. den entsprechenden HF-Leistungssendern verbunden und von dem bzw. den zugeordneten Empfangskanälen getrennt ist/sind, während für die Empfangsphasen eine Senderabtrennung und eine Empfangskanalverbindung vorgenommen wird.

Mit den in Fig. 1 dargestellten Empfangseinheiten RX1 bis RXm werden die empfangenen Signale verstärkt, unter Verwendung bekannter Signalverarbeitungsverfahren in digitale Signale gewandelt und an ein elektronisches Rechnersystem **COMP** weiterleitet. Neben der Rekonstruktion von Bildern und Spektren und abgeleiteter Größen aus den empfangenen Messdaten dient das Steuerrechnersystem COMP dazu, das gesamte MR-Messapparatur zu bedienen und die Ausführung der Pulssequenzen durch entsprechende Kommunikation mit der Sequenzsteuereinheit SEQ zu initiieren. Die benutzergeführte oder automatische Ausführung von Programmen zur Justage der Messapparatureigenschaften und/oder zur Erzeugung von Magnetresonanzbildern erfolgt ebenso auf diesem Steuerrechnersystem COMP wie die Darstellung der rekonstruierten Bilder und die Speicherung und Verwaltung der Mess- und Bilddaten und der Steuerprogramme. Für diese Aufgaben ist dieses Rechnersystem mindestens mit einem Prozessor, einem Arbeitsspeicher, einer Computertastatur **KB**, einem Zeigeinstrument **PNTR**, z. B. einer Computermaus, einem Bildschirm **MON** und einer externen digitalen Speichereinheit **DSK** ausgerüstet.

Im Folgenden wird anhand eines konkreten Ausführungsbeispiels erläutert, wie das erfindungsgemäße Verfahren mit einer solchen MR-Messapparatur durchgeführt werden kann. Die gezeigten Resultate wurden durch rechnerische Simulation eines MR-Experimentes gewonnen, bei dem eine angenommene ortsabhängige Ausgangsmagnetisierung in einem Untersuchungsobjekt durch Einstrahlung von HF-Pulsen und gleichzeitiger Wirkung von Zusatzmagnetfeldern gemäß dem erfindungsgemäßen Verfahren in eine ortsabhängige Zielmagnetisierung überführt wird.

Erfindungsgemäß werden mindestens zwei Zusatzmagnetfelder verwendet (Fig. 2), die einen räumlichen Gradienten der z-Komponente aufweisen, der nicht konstant ist, da die z-Komponente nichtlinear vom Ort abhängt. Auch die z-Komponente der Superposition dieser Zusatzmagnetfelder besitzt zu allen Zeitpunkten, an denen mindestens eines dieser Zusatzfelder wirksam ist, einen nichtkonstanten Gradienten.

Beispielhaft für die in Anspruch 2 beschriebene Sachlage werden zwei äquivalente Orte aufgezeigt. Einerseits wird im Folgenden für dieses Beispiel gezeigt, dass bei Verwendung von einer Sendeantenne an diesen beiden Orten eine identische, damit nur eine voneinander abhängige Änderung der Magnetisierung erfolgt und die gewünschte ortsabhängige Änderung der Magnetisierung nur partiell realisiert wird. Andererseits wird verdeutlicht, dass bei Verwendung von acht Sendeantennen mit verschiedenen räumlichen Sendeprofilen gemäß dem erfinderischen Verfahren eine unterschiedliche, voneinander unabhängige Änderung der Magnetisierung an diesen beiden Orten bewirkt werden kann und damit an beiden Orten die gewünschte Änderung der Magnetisierung realisiert werden kann.

Fig. 2 zeigt die räumlichen Verläufe der beiden verwendeten Zusatzmagnetfelder $F_1$ und $F_2$, welche mit den Spulen G1 und G2 des lokalen Gradientensystems in Fig. 1 erzeugt werden, während Fig. 3 den zeitlichen Verlauf der Amplituden $A_1$ und $A_2$ dieser Felder während des Sendens der HF-Pulse zeigt. Die Basis für die Berechnung der HF-Pulse liegt hier also beispielhaft gemäß Anspruch 1 vor.

Die Ausgangssituation für dieses Ausführungsbeispiel ist eine in zwei Dimensionen ortsabhängige Magnetisierung $\mathbf{M}(0,\mathbf{r})$ innerhalb des Untersuchungsobjektes, wobei die Magnetisierung an jedem Ort des zweidimensionalen Objekts auf einem 96x96 Punkte großen Gitter mit der Ausdehnung 6cmx6cm in z-Richtung ausgerichtet ist. Die Stärke dieser z-Komponente entspricht dem Wert $M_z(0,\mathbf{r}) = M_0 = \cos(0°) = 1$. Die gezielte ortsabhängige Änderung der Magnetisierung mit dem erfindungsgemäßen Verfahren soll so erfolgen, daß die x-Komponente der Magnetisierung durch die kombinierte Anwendung der Zusatzmagnetfelder und von HF-Pulsen die in Fig. 4 dargestellte Verteilung, auch als Zielverteilung $\mathbf{M}_T(\mathbf{r})$ bezeichnet erhält. Hier entsprechen in Weiß dargestellte Flächen einer nichtverschwindenden Komponente $M_x$ von $\sin(90°) = 1$ und in Schwarz dargestellte Flächen repräsentieren $M_x = 0$. Die z-Komponente der Magnetisierung reduziere sich in den weißen Bereichen auf $M_z = \cos(90°) = 0$, während $M_y$ überall unverändert gleich Null bleiben soll.

Ein wesentlicher Teil des erfindungsgemäßen Verfahrens ist die Bestimmung der zeitlichen Verläufe der einzustrahlenden Hochfrequenzpulse. Im Folgenden ist beispielhaft eine mögliche Vorgehensweise für diese Berechnung beschrieben, ohne auf vielfältige Alternativen und Variationen, die dem Fachmann nahe liegen, einzugehen. Zunächst wird für die im Folgenden durchzuführende iterative Lösung der Blochschen Gleichung ein Kleinwinkelpuls als Ausgangspunkt benötigt. Die Phase $\varphi$, die die zum Zeitpunkt $t$ erzeugte infinitesimalen Transversalmagnetisierung bis zum Ende der Anwendung der Zusatzmagnetfelder noch von diesen Feldern aufgeprägt bekommt, wird für die Berechnung des Kleinwinkelpulses benötigt. Diese Berechung erfolgt nach dem erfindungsgemäßen Verfahren explizit aus den bekannten, in diesem Fall elektrodynamisch berechneten, räumlichen Verläufen der Zusatzmagnetfelder $F_1$ und $F_2$ und den durch die Sequenzsteuerung der MR-Messapparatur vorgegebenen zeitlichen Verläufen $A_1$ und $A_2$ als

$$\varphi(t,\mathbf{r}) = -\gamma \int_t^T dt' \, F_1(\mathbf{r})A_1(t') + F_2(\mathbf{r})A_2(t') \tag{8}$$

Damit ergibt sich die folgende Designgleichung im Kleinwinkelregime

$$M_{xy}(\mathbf{r}) = i\gamma M_0(\mathbf{r}) \int_0^T dt \sum_l S_l(\mathbf{r})I_l(t) \exp\left[-i\gamma \int_t^T dt' \, F_1(\mathbf{r})A_1(t') + F_2(\mathbf{r})A_2(t')\right] \tag{9}$$

Hierbei sind $S_l(\mathbf{r})$ die Sendeprofile der zur HF-Pulsform $I_l(t)$ gehörigen HF-Sendeantenne. In Fig. 7 sind die relativen Amplituden der verwendeten Sendeprofile dargestellt. Weiterhin bezeichnet r die Ortsvariable, $t$ die Zeitvariable, $M$ die Magnetisierung, $\gamma$ das gyromagnetische Verhältnis des Protons und $T = 83,1$ ms die Gesamtdauer der HF-Pulse und der Anwendung der Zusatzmagnetfelder. Die Zielmagnetisierungsverteilung $M_{xy}(\mathbf{r})$ für das Kleinwinkel-Pulsdesign geht aus der oben beschriebenen Zielverteilung (siehe auch Fig. 4) dadurch hervor, dass in den weißen Bereichen $M_x = \sin(10°) = 0.17$ gesetzt wird, $M_y$ ist unverändert gleich Null. Im Kleinwinkel-Pulsdesign wird außerdem $M_z$ als zeitlich konstant angenommen.

Die Lösung der Designgleichung (9) nach den die acht HF-Pulsformen $I_l(t)$ erfolgt nach Diskretisierung und Umwandlung in ein quadratisches Minimierungsproblem numerisch mit dem allgemein bekannten Conjugate Gradient-Verfahren.

Die so gewonnenen Kleinwinkelpulse (Gesamtheit der acht HF-Pulsformen) wird nun mit dem Faktor 9 skaliert, d.h. mit dem Verhältnis zwischen gewünschtem Veränderungswinkel der ortsabhängigen Magnetisierung (hier 90°) und angenommenem Veränderungswinkel der ortsabhängigen Magnetisierung bei der Kleinwinkelberechnung (hier 10°). Der skalierte HF-Puls ist der Ausgangspunkt für die folgende iterative Optimierung mittels Optimal Control.

Die nun folgenden Iterationsschritte werden solange durchgeführt, bis die Abweichung $\lambda(\mathbf{r})$ der simulierten ortsabhängigen Magnetisierung der jeweiligen Iteration von der gewünschten ortsabhängigen Magnetisierung hinreichend klein ist (siehe Schritt 2).

Schritt 1:

Aus den acht HF-Pulsformen und den acht Sendeprofilen, wird über

$$B_1(t,\mathbf{r}) = \sum_l S_l(\mathbf{r})I_l(t) \tag{10}$$

das Sendefeld $B_1(t,\mathbf{r})$ und aus den räumlichen und zeitlichen Verläufen der z-Komponente der Zusatzmagnetfelder der Verlauf der Superposition

$$\Delta B_0(t,\mathbf{r}) = F_1(\mathbf{r})A_1(t) + F_2(\mathbf{r})A_2(t) \tag{11}$$

berechnet. Mit diesen Funktionen wird die Blochsche Gleichung

$$\begin{pmatrix} \dot{M}_x(t,\mathbf{r}) \\ \dot{M}_y(t,\mathbf{r}) \\ \dot{M}_z(t,\mathbf{r}) \end{pmatrix} = \gamma \begin{pmatrix} 0 & \Delta B_0(t,\mathbf{r}) & -B_{1,y}(t,\mathbf{r}) \\ -\Delta B_0(t,\mathbf{r}) & 0 & B_{1,x}(t,\mathbf{r}) \\ B_{1,y}(t,\mathbf{r}) & -B_{1,x}(t,\mathbf{r}) & 0 \end{pmatrix} \bullet \begin{pmatrix} M_x(t,\mathbf{r}) \\ M_y(t,\mathbf{r}) \\ M_z(t,\mathbf{r}) \end{pmatrix} \qquad (12)$$

ausgehend von der Ausgangsmagnetisierung $\mathbf{M}(0,\mathbf{r})$ an jedem Ort r vorwärts in der Zeit bis zur Gesamtdauer $T$ numerisch integriert, mit dem Ergebnis $\mathbf{M}(T,\mathbf{r})$. Hierbei sind $B_{1,x}(t,\mathbf{r})$ und $B_{1,y}(t,\mathbf{r})$ Real- und Imaginärteil des Sendefeldes und der Verlauf von $\mathbf{M}(t,\mathbf{r})$ wird für jeden Zeitpunkt und jeden Ort gespeichert.

Schritt 2:

Durch Bilden der vektoriellen Differenz zwischen der in Schritt 1 erhaltenen ortsabhängigen Magnetisierung und der Zielmagnetisierung wird die Abweichung

$$\lambda(\mathbf{r}) = \mathbf{M}(T,\mathbf{r}) - \mathbf{M}_T(\mathbf{r}) \qquad (13)$$

berechnet. Falls der Mittelwert der Betragsquadrate von $\lambda$ über alle Orte kleiner als 0,025 ist, die mittlere quadratische Abweichung also unterhalb 2.5% liegt, wird die Iteration hier beendet und die acht Pulsformen der aktuellen Iteration stellen das Ergebnis der Großwinkel-HF-Pulsberechnung dar. Andernfalls wird mit Schritt 3 fortgefahren.

Schritt 3:

Die Blochsche Gleichung für die vektorielle Abweichung $\lambda$

$$\begin{pmatrix} \dot{\lambda}_x(t,\mathbf{r}) \\ \dot{\lambda}_y(t,\mathbf{r}) \\ \dot{\lambda}_z(t,\mathbf{r}) \end{pmatrix} = \gamma \begin{pmatrix} 0 & \Delta B_0(t,\mathbf{r}) & -B_{1,y}(t,\mathbf{r}) \\ -\Delta B_0(t,\mathbf{r}) & 0 & B_{1,x}(t,\mathbf{r}) \\ B_{1,y}(t,\mathbf{r}) & -B_{1,x}(t,\mathbf{r}) & 0 \end{pmatrix} \bullet \begin{pmatrix} \lambda_x(t,\mathbf{r}) \\ \lambda_y(t,\mathbf{r}) \\ \lambda_z(t,\mathbf{r}) \end{pmatrix} \qquad (14)$$

wird unter Verwendung der Sendefelder und der Superposition der Zusatzmagnetfelder aus Schritt 1 an jedem Ort $\mathbf{r}$ rückwärts in der Zeit integriert (d.h. A = $\lambda(T,\mathbf{r})$ ist der Ausgangspunkt für die Integration in negativen Zeitschritten, bis hin zu $t = 0$), und der Verlauf von $\lambda(t,\mathbf{r})$ für jeden Zeitpunkt und jeden Ort gespeichert. Gemäß den bekannten Prinzipien der Variationsrechnung, welche dem Optimal Control Verfahren zugrunde liegen, berechnen sich verbesserte Großwinkel-HF-Pulsformen $I_l(t)^{\text{opt}}$ aus den Sendeprofilen und den Verläufen von $\mathbf{M}(t,\mathbf{r})$, $\lambda(t,\mathbf{r})$ und $I_l(t)$ durch

$$I_l(t)^{\text{opt}} = I_l(t) - \mu \sum_{\mathbf{r}} \lambda(t,\mathbf{r})^{\text{T}} \bullet \begin{pmatrix} 0 & 0 & -iS_l^*(\mathbf{r}) \\ 0 & 0 & S_l^*(\mathbf{r}) \\ iS_l^*(\mathbf{r}) & -S_l^*(\mathbf{r}) & 0 \end{pmatrix} \bullet \mathbf{M}(t,\mathbf{r}) \qquad , \qquad (15)$$

wobei eine Schrittweite $\mu = 2.5 \times 10^{-8}$ gewählt wurde. Mit den verbesserten HF-Pulsformen $I_l(t)^{\text{opt}}$ wird mit Schritt 1 fortgefahren.

In Fig. 8 ist das Resultat einer Simulation der ortsabhängigen Änderung der Magnetisierung nach einem Verfahren dargestellt, das dem erfindungsgemäßen Verfahren bis auf die Zahl der verwendeten Sendespulen entspricht. Das Ergebnis bei Verwendung genau einer Sendespule mit homogenem Sendeprofil zeigt eine unerwünschte Vervielfachung des Zielmusters, da bei Verwendung nur einer Sendespule die unabhängige Änderung der Magnetisierung an den äquivalenten Orten wie z. B. $\mathbf{r}_1$ und $\mathbf{r}_2$ (siehe Fig. 5) nicht möglich ist.

Das Resultat einer Simulation der ortsabhängig modifizierten Magnetisierung nach erfindungsgemäßem Verfahren ist in Fig. 9 dargestellt. Die Realisierung der Zielmagnetisierung wird durch die zusätzliche Ortsselektivität der acht verwendeten Sendeantennen, TA1 bis TA8 in Fig. 1, ermöglicht.

Die Eigenschaft eines nichtkonstanten Gradienten der Zusatzmagnetfelder kann weiterhin vorteilhaft eingesetzt werden, um die Änderung der Magnetisierung gemäß Anspruch 3 mit örtlich variierender Auflösung zu bewerkstelligen, wie in Fig. 10 bis 12 verdeutlicht ist. Die Änderung der Magnetisierung erfolgt zunächst nach erfindungsgemäßem Verfahren wie im obigen Beispiel dargestellt, mit der Änderung, daß die ortsabhängige Zielmagnetisierung durch das in Fig. 10 dargestellte Muster ersetzt wird. Das Resultat einer Simulation einer solcherart modifizierten ortsabhängigen Magnetisierung ist in Fig. 12 dargestellt. Im Vergleich dazu zeigt Fig. 11 eine nach dem Stand der Technik modifizierte Magnetisierung unter Verwendung von linearen Zusatzmagnetfeldern, deren Maximalamplitude im Objekt mit derjenigen aus dem erfindungsgemäßen Verfahren übereinstimmt. Es ist ersichtlich, dass das Ortsauflösungsvermögen in Fig. 12 räumlich variiert und dass das erfindungsgemäße Verfahren die Magnetisierung in den Randbereichen des Abbildungsbereichs entsprechend der Auflösung der Zielmagnetisierung realisieren kann, wohingegen das Verfahren nach Stand der Technik dies an keiner Stelle leisten kann.

**Bezugszeichenliste**

| | |
|---|---|
| A | Arrayelement |
| AX, AY, AZ, A1, A2 | Gradientenverstärker |
| COMP | Rechnersystem |
| DSK | Speichereinheit |
| F1, F2 | nicht-lineare Zusatzmagnetfelder |
| GX, GY, GZ, G1, G2 | Gradientenspulen |
| $G_x$, $G_y$, $G_z$ | Gradienten |
| KB | Computertastatur |
| M | Hauptmagnet |
| MON | Bildschirm |
| O | Untersuchungsobjekt |
| PNTR | Zeigeinstrument |
| $RA_{1..m}$ | HF-Empfangsantennen |
| $RX_{1...m}$ | Empfangseinheiten |
| SEQ | Sequenzsteuereinheit |
| $TA_{1...n}$ | HF-Sendeantennen |
| $TX_{1...n}$ | HF-Leistungssender |
| V | Untersuchungsvolumen |

**Referenzen**

[1] Xu, D.; King, K. F.; Zhu, Y.; McKinnon, G. C.; Liang, Z. P.: Designing Multichannel, Multidimensional, Arbitrary Flip Angle RF Pulses Using an Optimal Control Approach, Magnetic Resonance in Medicine 59 (2008), 547-560.

[2] Bernstein, M.A. ; King K. F. ; Zhou, X. J.: Handbook of MRI Pulse Sequences. Elsevier Academic Press (2004).

[3] de Graaf, R. A.: In vivo NMR spectroscopy. John Wiley & Sons Ltd (1998).

[4] DE 10 2005 051 021 A1

[5] Hennig, J.; Welz, A. M.; Schultz, G.; Korvink, J.; Liu, Z.; Speck, O.; Zaitsev, M.: Parallel imaging in non-bijective, curvilinear magnetic field gradients: a concept study, Magn. Reson. Mater. Phy. 21 (2008), 5-14.

[6] Pauly, J. ; Nishimura, D.; Macovski A.: A k-space analysis of small-tip-angle excitation, Journal of Magnetic Resonance 81 (1989), 43-56.

[7] Katscher U.; Börnert, P.; Leussler, C.; van den Brink, J. S.: Transmit SENSE, Magnetic Resonance in Medicine 49 (2003), 144-150.

[8] Meyer, C. H.; Pauly, J. M.; Macovski, A.; Nishimura, D. G.: Simultaneous spatial and spectral selective excitation, Magnetic Resonance in Medicine 15 (1990), 287-304.

[9] Setsompop, K.; Alagappan, V.; Gagoski, B.; Wald, L.; Adalsteinsson, E.: Uniform Wideband Slab Selection with B1 + Mitigation at 7T via Parallel Spectral-Spatial Excitation, Proceedings 16th Scientific Meeting, International Society for Magnetic Resonance in Medicine (2008), 616.

[10] Schomberg, H.; Börnert, P.: Off-resonance correction of nD spatially selective RF pulses, Proceedings 6th Scientific Meeting, International Society for Magnetic Resonance in Medicine (1998), 2059.

[11] Börnert, P.; Aldefeld, B.: On spatially selective RF excitation and its analogy with spiral MR image acquisition, Magnetic Resonance Materials in Physics, Biology and Medicine 7 (1998), 166-178.

[12] Pruessmann, K. P.; Weiger, M.; Scheidegger M. B.; Boesiger, P.: SENSE: Sensitivity Encoding for Fast MRI, Magnetic Resonance in Medicine 42 (1999), 952-962.

[13] Ullmann, P.; Haas, M.; Hennel, F.; Wick, M.; Voiron, J.; Zaitsev, M.; Hennig, J.; Ruhm, W.: Parallel Excitation Experiments Using Measured k-Space Trajectories for Pulse Calculation, Proceedings 16th Scientific Meeting, International Society for Magnetic Resonance in Medicine (2008), 1313.

[14] Nicht-vorveröffentlichte, am 01.04.2009 beim Deutschen Patent- und Markenamt eingereichte Patentanmeldung mit dem amtlichen Aktenzeichen 10 2009 002 112.4.

[15] Yip, C.; Fessler, J.A.; Noll, D.C.: Advanced Three-Dimensional Tailored RF Pulses for Signal Recovery in T*2-Weighted Functional Magnetic Resonance, Magnetic Resonance in Medicine 56 (2006), 1050-2059.

[16] DE 10 2007 044 463 B4

**Patentansprüche**

1. Verfahren zur ortsabhängigen Änderung der Magnetisierung in einem Objekt, gemäß einer Vorgabe im Rahmen eines Experimentes der magnetischen Resonanz, wobei Hochfrequenzpulse in Kombination mit räumlich und zeitlich variierenden Zusatzmagnetfeldern, die dem längs einer z-Richtung ausgerichteten statischen und homogenen magnetischen Grundfeld einer Magnetresonanz-Messapparatur überlagert werden, eingestrahlt werden,
**dadurch gekennzeichnet,**
**dass** nicht-lineare Zusatzmagnetfelder angewendet werden, deren räumlicher Gradient der z-Komponente zu mindestens einem Zeitpunkt der Einstrahlung nicht konstant ist, und dass die einzustrahlenden Hochfrequenzpulse vorab berechnet werden, wobei im Bereich des Objekts zeitliche Verläufe der Feldstärken der Zusatzmagnetfelder, welche ortsabhängig berechnet und/oder gemessen werden, explizit in diese Berechnung eingehen.

2. Verfahren nach Anspruch 1, **dadurch gekennzeichnet, dass** beim Auftreten mindestens einer Gruppe von äquivalenten Orten innerhalb des Objekts - welche sich dadurch auszeichnen, dass bei Einstrahlung mit einer einzigen Hochfrequenz-Sendeantenne, deren Sendeprofil das gesamte Objekt abdeckt, die Änderungen der Magnetisierung an den äquivalenten Orten nicht unabhängig voneinander durchgeführt werden können - durch die Verwendung mindestens zweier Sendeantennen mit verschiedenen räumlichen Sendeprofilen die Änderung der Magnetisierung an mindestens einem dieser äquivalenten Orte unabhängig von den Änderungen der Magnetisierung an den anderen Orten dieser Gruppe durchgeführt wird.

3. Verfahren nach einem der vorgehenden Ansprüche, **dadurch gekennzeichnet; dass** Zusatzmagnetfelder verwendet werden, die so beschaffen sind, dass die Änderung der Magnetisierung mit räumlich variierender Ortsauflösung erfolgt.

4. Verfahren nach einem der vorgehenden Ansprüche, **dadurch gekennzeichnet, dass** die Vorgabe der ortsabhängigen Änderung der Magnetisierung so gewählt wird, dass die Magnetisierung selektiv nur in einer oder mehreren Regionen innerhalb des Objektes eine nichtverschwindende Änderung erfährt.

5. Verfahren nach Anspruch 4, **dadurch gekennzeichnet, dass** mindestens eine Region so gewählt wird, dass sie an anatomische, morphologische oder funktionelle Gegebenheiten des Untersuchungsobjekts und/oder an die Abbildungseigenschaften der Magnetresonanz-Messapparatur angepasst ist.

6. Verfahren nach Anspruch 4, **dadurch gekennzeichnet, dass** die Regionen so gewählt werden, dass die aus der Gesamtheit aller Regionen stammenden MR-Signale mit dem im Rahmen der Datenaufnahme verwendeten Gradientensystem eindeutig ortskodiert werden können.

7. Verfahren nach einem der vorgehenden Ansprüche, **dadurch gekennzeichnet, dass** die Phase der Transversalmagnetisierung entsprechend einer vorgegebenen räumlichen Verteilung geändert wird.

8. Verfahren nach Anspruch 7, **dadurch gekennzeichnet, dass** im Rahmen eines Experimentes der magnetischen Resonanz die Änderung der räumlichen Verteilung der Phasen der Transversalmagnetisierung wiederholt in mindestens zwei Phasenkodierperioden entsprechend einem Ortskodierschema erfolgt, dass nach jeder dieser Phasenkodierperioden eine Datenaufnahme vorgenommen wird, und dass die Gesamtheit der so aufgenommenen Daten dem Ortskodierschema entsprechend ortsaufgelöst rekonstruiert und abgespeichert und/oder bildhaft dargestellt wird.


**Claims**

1. Method for position dependent change in the magnetization in an object, according to a requirement, in a magnetic resonance experiment, wherein radio-frequency pulses are irradiated in conjunction with supplementary magnetic fields varying in space and over time that are superposed on the static and homogeneous basic magnetic field of a magnetic resonance measurement apparatus oriented along a z-direction,
**characterized in that**
non-linear supplementary magnetic fields are used, whose spatial gradient of the z-component is not constant at least at one instant during the irradiation, and that the radio-frequency pulses to be irradiated are calculated in advance, wherein dependences over time of the field strengths of the supplementary magnetic fields in the region of the object that are calculated and/or measured position-dependently are explicitly included in this calculation.

2. Method according to claim 1, **characterized in that**, if at least one group of equivalent positions occurs within the object - which are **characterized in that**, during irradiation with a single radio-frequency transmission antenna whose transmission profile covers the entire object, the changes in the magnetization at the equivalent positions cannot be performed mutually independently - the magnetization at least at one of these equivalent positions is changed independently of the changes in the magnetization at the other positions of this group by using at least two transmission antennas having different spatial transmission profiles.

3. Method according to any one of the previous claims, **characterized in that** supplementary magnetic fields are used which are designed such that the change in the magnetization is performed with spatially varying spatial resolution.

4. Method according to any one of the previous claims, **characterized in that** the setting of the position dependent change in the magnetization is chosen such that the magnetization undergoes a non-vanishing change selectively only in one or more regions within the object.

5. Method according to claim 4, **characterized in that** at least one region is chosen such that it is adapted to anatomical, morphological, or functional circumstances of the object under examination and/or to the mapping characteristics of the magnetic resonance measurement apparatus.

6. Method according to claim 4, **characterized in that** the regions are chosen such that the MR signals originating from the totality of all regions can be uniquely spatially encoded with the gradient system used in data acquisition.

7. Method according to any one of the previous claims, **characterized in that** the phase of the transverse magnetization is changed according to a defined spatial distribution.

8. Method according to claim 7, **characterized in that**, in a magnetic resonance experiment, the change in the spatial distribution of the phases of the transverse magnetization is performed repeatedly in at least two phase encoding periods according to a spatial encoding scheme, that, after each of these phase encoding periods, data acquisition is performed, and that the totality of the data acquired in this way is reconstructed having been resolved spatially according to the spatial encoding scheme and stored and/or displayed as an image.

**EP 2 325 669 B1**

**Revendications**

1. Procédé de modification en fonction du lieu de la magnétisation dans un objet selon une spécification dans le cadre d'une expérience de résonance magnétique, dans lequel des impulsions à haute fréquence sont irradiées en combinaison avec des champs magnétiques supplémentaires variant dans l'espace et dans le temps, qui sont superposés au champ magnétique de base statique et homogène, orienté suivant une direction z, d'un appareil de mesure de résonance magnétique,

**caractérisé en ce**

**que** l'on utilise des champs magnétiques supplémentaires non linéaires dont le gradient spatial de la composante z n'est pas constant à au moins un instant de l'irradiation, et que les impulsions à haute fréquence à irradier sont calculées au préalable, des variations dans le temps des intensités de champ des champs magnétiques supplémentaires dans la zone de l'objet, qui sont calculées et/ou mesurées en fonction du lieu, étant prises en compte explicitement dans ce calcul.

2. Procédé selon la revendication 1, **caractérisé en ce qu'**en cas d'apparition d'au moins un groupe de lieux équivalents à l'intérieur de l'objet - lesquels se caractérisent par le fait qu'en cas d'irradiation avec une seule antenne d'émission à haute fréquence, dont le profil d'émission couvre l'ensemble de l'objet, les modifications de la magnétisation aux lieux équivalents ne peuvent pas être effectuées indépendamment les unes des autres - la modification de la magnétisation est effectuée à au moins un de ces lieux équivalents, indépendamment des modifications de la magnétisation aux autres lieux de ce groupe, par l'utilisation d'au moins deux antennes d'émission ayant des profils spatiaux d'émission différents.

3. Procédé selon l'une des revendications précédentes, **caractérisé en ce que** l'on utilise des champs magnétiques supplémentaires qui sont conçus de façon que la modification de la magnétisation ait lieu avec une résolution locale variable dans l'espace.

4. Procédé selon l'une des revendications précédentes, **caractérisé en ce que** la spécification de la modification en fonction du lieu de la magnétisation est choisie de façon que la magnétisation connaisse une modification non évanouissante sélectivement seulement dans une ou plusieurs régions à l'intérieur de l'objet.

5. Procédé selon la revendication 4, **caractérisé en ce qu'**au moins une région est choisie de façon à être adaptée à des conditions anatomiques, morphologiques ou fonctionnelles de l'objet analysé et/ou aux propriétés de reproduction de l'appareil de mesure de résonance magnétique.

6. Procédé selon la revendication 4, **caractérisé en ce que** les régions sont choisies de façon que les signaux de RM provenant de la totalité des régions puissent être codés localement de manière univoque avec le système de gradients utilisé dans le cadre de l'acquisition de données.

7. Procédé selon l'une des revendications précédentes, **caractérisé en ce que** la phase de la magnétisation transversale est modifiée conformément à une distribution spatiale spécifiée.

8. Procédé selon la revendication 7, **caractérisé en ce que** dans le cadre d'une expérience de résonance magnétique, la modification de la distribution spatiale des phases de la magnétisation transversale a lieu de façon répétée dans au moins deux périodes de codage de phase conformément à un schéma de codage local, qu'une acquisition de données est effectuée après chacune de ces périodes de codage de phase, et que la totalité des données ainsi acquises est reconstruite avec résolution locale conformément au schéma de codage local et enregistrée et/ou représentée sous la forme d'une image.

PRIOR ART

Fig. 1

EP 2 325 669 B1

**A2**

**Fig. 2**

Fig. 3

Fig. 4

EP 2 325 669 B1

**Fig. 5**

Fig. 6

Fig. 7

**Fig. 8**

EP 2 325 669 B1

Fig. 9

Fig. 10

Fig. 11

Fig. 12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005051021 A1
- DE 102009002112
- DE 102007044463 B4


**In der Beschreibung aufgeführte Nicht-Patentliteratur**

- **WELZ A.M. et al.** Initial realisation of a multichannel, non-linear PatLoc gradient coil. *Proc. Intl. Soc. Mag. Reson. Med.,* 2008, 1163
- **XU, D. ; KING, K. F. ; ZHU, Y. ; MCKINNON, G. C. ; LIANG, Z. P.** Designing Multichannel, Multidimensional, Arbitrary Flip Angle RF Pulses Using an Optimal Control Approach. *Magnetic Resonance in Medicine,* 2008, vol. 59, 547-560
- **BERNSTEIN, M.A. ; KING K. F. ; ZHOU, X. J.** Handbook of MRI Pulse Sequences. Elsevier Academic Press, 2004
- **DE GRAAF, R. A.** In vivo NMR spectroscopy. John Wiley & Sons Ltd, 1998
- **HENNIG, J. ; WELZ, A. M. ; SCHULTZ, G. ; KORVINK, J. ; LIU, Z. ; SPECK, O. ; ZAITSEV, M.** Parallel imaging in non-bijective, curvilinear magnetic field gradients: a concept study, Magn. *Reson. Mater. Phy.,* 2008, vol. 21, 5-14
- **PAULY, J. ; NISHIMURA, D. ; MACOVSKI A.** A k-space analysis of small-tip-angle excitation. *Journal of Magnetic Resonance,* 1989, vol. 81, 43-56
- **KATSCHER U. ; BÖRNERT, P. ; LEUSSLER, C. ; VAN DEN BRINK, J. S.** Transmit SENSE. *Magnetic Resonance in Medicine,* 2003, vol. 49, 144-150
- **MEYER, C. H. ; PAULY, J. M. ; MACOVSKI, A. ; NISHIMURA, D. G.** Simultaneous spatial and spectral selective excitation. *Magnetic Resonance in Medicine,* 1990, vol. 15, 287-304
- **SETSOMPOP, K. ; ALAGAPPAN, V. ; GAGOSKI, B. ; WALD, L. ; ADALSTEINSSON, E.** Uniform Wideband Slab Selection with B1 + Mitigation at 7T via Parallel Spectral-Spatial Excitation. *Proceedings 16th Scientific Meeting, International Society for Magnetic Resonance in Medicine,* 2008, 616
- **SCHOMBERG, H. ; BÖRNERT, P.** Off-resonance correction of nD spatially selective RF pulses. *Proceedings 6th Scientific Meeting, International Society for Magnetic Resonance in Medicine,* 1998, 2059
- **BÖRNERT, P. ; ALDEFELD, B.** On spatially selective RF excitation and its analogy with spiral MR image acquisition. *Magnetic Resonance Materials in Physics, Biology and Medicine,* 1998, vol. 7, 166-178
- **PRUESSMANN, K. P. ; WEIGER, M. ; SCHEIDEGGER M. B. ; BOESIGER, P.** SENSE: Sensitivity Encoding for Fast MRI. *Magnetic Resonance in Medicine,* 1999, vol. 42, 952-962
- **ULLMANN, P. ; HAAS, M. ; HENNEL, F. ; WICK, M. ; VOIRON, J. ; ZAITSEV, M. ; HENNIG, J. ; RUHM, W.** Parallel Excitation Experiments Using Measured k-Space Trajectories for Pulse Calculation. *Proceedings 16th Scientific Meeting, International Society for Magnetic Resonance in Medicine,* 2008, 1313
- **YIP, C. ; FESSLER, J.A. ; NOLL, D.C.** Advanced Three-Dimensional Tailored RF Pulses for Signal Recovery in T*2-Weighted Functional Magnetic Resonance. *Magnetic Resonance in Medicine,* 2006, vol. 56, 1050-2059